# EUROPEAN PATENT APPLICATION

(11) **EP 4 362 613 A1**
(43) Date of publication of application: **01.05.2024**
(21) Application number: 22874612.9
(22) Date of filing: 13.09.2022
(51) Int. Cl.: H05K 1/18, H05K 1/02

(54) **ELECTRONIC DEVICE AND CHIP ASSEMBLY**

(30) Priority: 30.09.2021 CN 202111166647
(71) Applicant: Huawei Technologies Co., Ltd., Longgang Shenzhen, Guangdong 518129 (CN)
(72) Inventor: WU, Xuesheng, Shenzhen, Guangdong 518129 (CN); WANG, Feng, Shenzhen, Guangdong 518129 (CN); CHEN, Zongxun, Shenzhen, Guangdong 518129 (CN)
(74) Representative: Epping - Hermann - Fischer
(86) International application number: PCT/CN2022/118353
(87) International publication number: WO 2023/051225

(57) **Abstract**

Embodiments of this application provide an electronic device and a chip assembly. A protruding portion extending in a direction towards a first clamping member is formed on a second clamping member of the chip assembly, and the protruding portion is disposed in an area enclosed by all first fasteners. In addition, at least a part of an orthographic projection area of the protruding portion on a circuit board is disposed in a chip layout area of the circuit board (that is, an orthographic projection area of a chip on the circuit board), so as to support the circuit board, that is, to provide a specific support force for the chip layout area of the circuit board, thereby ensuring close contact between the chip and the chip socket or between the chip socket and the circuit board, and implementing a stable electrical connection between the chip and the circuit board.

## Description

This application claims priority to Chinese Patent Application No. 202111166647.8, filed with the China National Intellectual Property Administration on September 30, 2021 and entitled "ELECTRONIC DEVICE AND CHIP ASSEMBLY", which is incorporated herein by reference in its entirety.

### TECHNICAL FIELD

Embodiments of this application relate to the field of chip assembly technologies, and in particular, to an electronic device and a chip assembly.

### BACKGROUND

Currently, considering a requirement of chip serialization and convenience of chip maintenance, a growing quantity of manufacturers use a chip socket (also referred to as a socket) solution to assemble a chip. For example, in a common central processing unit socket (central processing unit socket, CPU socket for short) circuit system, the socket solution is used to assemble a central processing unit chip.

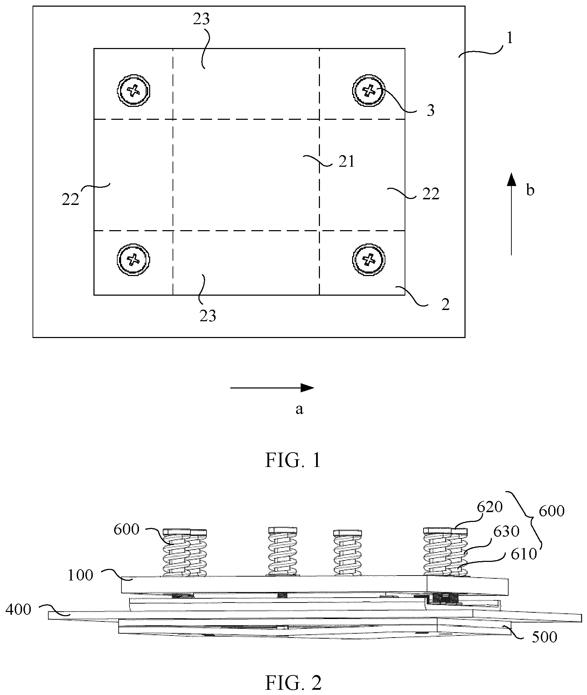

In a circuit system of a conventional chip assembly, such as a CPU socket circuit system, a chip socket having contacts on two sides is used as an example. The chip socket is located between a chip and a circuit board, and terminals on two sides of the chip socket are in electrical contact with both the chip and the circuit board. A heat sink is disposed on a side that is of the chip and that is away from the chip socket, and a plate-like member is disposed on a side that is of the circuit board and that is away from the chip socket. The chip, the chip socket, and the entire circuit board are fastened between the heat sink and the plate-like member by using a plurality of screws loaded on the edge of the chip assembly, so that the chip terminals are in good contact with both the chip and the circuit board. The plurality of screws are loaded at four corners on a periphery of the chip assembly, as shown in FIG. 1.

However, in a conventional chip assembly, a gap may be easily formed between a middle position of a chip socket and a circuit board or a chip, which affects reliability of contact between the middle position of the chip socket and the circuit board or the chip, and further reduces stability of an electrical connection between the chip and the circuit board.

### SUMMARY

Embodiments of this application provide an electronic device and a chip assembly, so as to improve reliability of contact between a middle position of a chip socket and a circuit board or a chip, thereby improving stability of an electrical connection between the chip and the circuit board.

According to one aspect, an embodiment of this application provides a chip assembly, where the chip assembly includes a first clamping member, a chip, a chip socket, a circuit board, and a second clamping member that are sequentially stacked, where the chip is electrically connected to the circuit board through the chip socket, and at least one side of the chip socket is in electrical contact with the chip or the circuit board. The chip assembly further includes a plurality of first fasteners disposed around the chip at intervals, to lock the first clamping member and the second clamping member. In addition, a protruding portion extending in a direction towards a first clamping member is formed on the second clamping member, and the protruding portion is disposed in an area enclosed by all first fasteners. In addition, at least a part of an orthographic projection area of the protruding portion on a circuit board is disposed in a chip layout area of the circuit board (that is, an orthographic projection area of a chip on the circuit board), so as to support the circuit board, that is, to provide a specific support force for the chip layout area of the circuit board, thereby ensuring close contact between the chip and the chip socket or between the chip socket and the circuit board, and implementing a stable electrical connection between the chip and the circuit board.

In a feasible implementation, the orthographic projection area of the protruding portion on the circuit board is located in the orthographic projection area of the chip on the circuit board. In other words, the orthographic projection area of the entire protruding portion on the circuit board is completely located in the orthographic projection area of the chip on the circuit board. In this way, the entire protruding portion effectively supports the chip layout area of the circuit board, to ensure close contact between the chip and the chip socket or between the chip socket and the circuit board.

In a feasible implementation, the second clamping member is disposed to include an upper clamping member, a lower clamping member, and a middle member located between the upper clamping member and the lower clamping member, and the middle member is used as a protruding portion. In this way, after the first fastener locks the entire chip assembly, the lower clamping member transfers an action force to the upper clamping member through the middle member, so that the upper clamping member supports a chip layout area (that is, an orthographic projection area of the chip on the circuit board) of the circuit board under abutting of the middle member, thereby ensuring even force distribution of the chip terminals on the chip socket, ensuring that at least one side of the chip socket is in good electrical contact with the chip or the circuit board, and improving stability of an electrical connection between the chip and the circuit board.

In a feasible implementation, an outer edge of the upper clamping member may be located outside the area enclosed by all the first fasteners.

The middle member transfers the action force to the circuit board through the upper clamping member, and the outer edge of the upper clamping member is located on a periphery of the area enclosed by all loading points of the first fasteners. This ensures continuity of the action force between the upper clamping member and the circuit board, avoids stress concentration on the circuit board, thereby ensuring that the circuit board is not damaged, and prolonging a service life of the chip assembly.

In a feasible implementation, an avoidance hole may be disposed on a side that is of the upper clamping member and that faces the circuit board. After the upper clamping member is attached to the circuit board, the electronic component is just located in the avoidance hole. This ensures that the upper clamping member is closely attached to the circuit board, avoids a case in which stress concentration occurs on the circuit board due to a gap between the upper clamping member and the circuit board, and avoids a case in which the upper clamping member squeezes and causes damage to the electronic component, thereby ensuring normal operation of the electronic component.

In actual application, electronic components are centrally arranged in the orthographic projection area of the chip on the circuit board. Based on this, in a feasible implementation, a first stiffener may be disposed in the avoidance hole, and at least a part of the first stiffener is in contact with the middle member, so as to ensure that the middle member transfers an action force to the upper clamping member, and then transfers the action force to the chip layout area of the circuit board, so that the chip layout area of the circuit board is supported by the first stiffener, thereby ensuring close contact between the chip socket and the chip and between the chip socket and the circuit board. In addition, the first stiffener is disposed in the avoidance hole. This further reinforces a structure of the avoidance hole, and ensures structural stability of the avoidance hole on the upper clamping member.

In a feasible implementation, the middle member and the lower clamping member are an integral part that is integrally formed, so that structural strengths of the middle member and the lower clamping member are improved, and a quantity of parts of the second clamping member is reduced, thereby simplifying a structure of the second clamping member, and improving manufacturing efficiency and assembly efficiency of the second clamping member.

In a feasible implementation, the second clamping member may be disposed as a plate-like member, and the plate-like member may specifically include a first plate-like member, a second plate-like member, and a middle portion, where the middle portion is located between the first plate-like member and the second plate-like member, and the first plate-like member is located on a side surface of the circuit board, so that the plate-like member can not only be used for packaging the chip, but also avoid damage caused by stress concentration on the circuit board, thereby simplifying a structure of the chip assembly.

In a feasible implementation, the surface that is of the second clamping member and that faces the circuit board is a curved surface bending in a direction towards the circuit board, so that a protruding portion is formed on a side that is of the second clamping member and that faces the circuit board. In this way, after the first fastener locks the entire chip assembly, the curved surface of the second clamping member bending towards the circuit board has a specific support force on the circuit board, so that two sides of the chip socket are in close contact with the chip and the circuit board, thereby ensuring even force distribution of the chip terminals, so as to ensure good electrical contact between at least one side of the chip socket and the chip or the circuit board. In addition, the outer edge of the second clamping member is located on a periphery of the area enclosed by all loading points of the first fasteners, that is, the load support points; and in the locked state, the curved surface of the second clamping member is in good contact with each position of the circuit board. This ensures continuity of an action force between each position of the second clamping member inside the load support point and the circuit board, and avoids stress concentration on the circuit board, thereby ensuring that the circuit board will not be damaged, and prolonging a service life of the chip assembly.

In a feasible implementation, at least a part of a highest area of the curved surface is located in the orthographic projection area of the chip on the second clamping member, so that when the chip assembly in this embodiment of this application is in a locked state, the highest area of the curved surface of the second clamping member just abuts against an area that is of the chip and that is corresponding to the circuit board (that is, the chip layout area of the circuit board), thereby further improving close contact between two sides of the chip socket and the circuit board and the chip. This ensures good electrical contact between the chip socket and the chip or between the chip socket and the circuit board, thereby implementing a stable electrical connection between the chip and the circuit board.

In a feasible implementation, the second clamping member is a plate-like member, and a surface that is of the plate-like member and that faces the circuit board is an arc-shaped surface bending in a direction towards the circuit board. In this way, the plate-like member can not only be used for packaging the chip, but also avoid damage caused by stress concentration on the circuit board, thereby simplifying the chip assembly.

In a feasible implementation, the plate-like member includes a first end and a second end that are disposed opposite to each other along an extension direction, a highest contour line of the curved surface is located on an axisymmetric line of the first end and the second end, and lowest contour lines of the curved surface are respectively located on the first end and the second end. In this way, the curved surface of the plate-like member is curved like an arch bridge, and an axisymmetric line of two sides of the plate-like member is the highest contour line of the curved surface, so that an area in which the entire axisymmetric line of the plate-like member is located may support the circuit board, that is, the plate-like member has an abutting function for each position of the circuit board in a width direction, thereby further ensuring that the circuit board in a locked state does not bend in a direction away from the chip.

In a feasible implementation, a side surface that is of the plate-like member and that is away from the circuit board is a plane, and a thickness of the plate-like member gradually decreases in a direction from the axisymmetric line to a first side or the second end. That is, the side surface that is of the plate-like member and that faces the circuit board is a curved surface, and the side surface that is of the plate-like member and that is away from the circuit board is a plane. This ensures that the curved surface of the plate-like member provides a supporting function for the circuit board, ensures that no stress concentration occurs on the circuit board, and simplifies a structure of the plate-like member, so that forming of the plate-like member is simplified, thereby improving manufacturing efficiency of the chip assembly.

In a feasible implementation, an electronic component is disposed on a side surface that is of the circuit board and that faces the second clamping member, and an avoidance groove is formed in a position that is of the second clamping member and that is corresponding to the electronic component. After the second clamping member is attached to the circuit board, the electronic component is just located in the avoidance groove. This ensures that the second clamping member is closely attached to the circuit board, avoids a case in which stress concentration occurs on the circuit board due to a gap between the second clamping member and the circuit board, and avoids a case in which the second clamping member squeezes and causes damage to the electronic component, thereby ensuring normal operation of the electronic component.

In a feasible implementation, a second stiffener may be disposed in the avoidance groove, and at least a part of an orthographic projection area of the second stiffener on the circuit board is disposed in the orthographic projection area of the chip, to ensure that the second stiffener on the second clamping member can transfer an action force to the chip layout area of the circuit board, so as to support the chip layout area of the circuit board to some extent, thereby ensuring close contact between the chip socket and the chip and between the chip socket and the circuit board. In addition, the first stiffener is disposed in the avoidance hole, which further reinforces a structure of the avoidance hole, and ensures structural stability of the avoidance hole on the upper clamping member.

In a feasible implementation, at least one first fastener may be disposed in the first-direction extension area or the second-direction extension area of the chip. Compared with the conventional technology in which first fasteners are disposed at four corners on a periphery of the chip, distances between some of the first fasteners and a center line of the chip layout area are reduced. This ensures that some first fasteners are disposed close to the center line of the chip layout area, improves an effect of fastening the chip assembly by the first fastener and improving rigidity of the chip assembly, thereby ensuring deformation amounts of the circuit board, the first clamping member, the second clamping member, and the like, improving evenness of force distribution of the chip socket, and ensuring good electrical contact between two sides of the chip socket and the chip or between the chip socket and the circuit board.

In a feasible implementation, at least one first fastener may be disposed in the first-direction extension area on two sides of the chip, or at least one first fastener may be disposed in the second-direction extension areas on two sides of the chip, so as to improve symmetry of loading points of the chip assembly, and further disperse the centralized load. This improves an overall effect of locking the first clamping member and the second clamping member, improves rigidity of the chip assembly, and reduces deformation amounts of the circuit board, the first clamping member, the second clamping member, and the like, thereby improving evenness of force distribution of the chip socket, and ensuring good electrical contact between two sides of the chip socket and the chip or between the chip socket and the circuit board. In addition, at least four first fasteners may be all disposed in extension areas of the chip in two directions, and are disposed around the chip. This further reduces spacings between load support points of the chip assembly, improves evenness of force distribution of the chip socket, and ensures good electrical contact between two sides of the chip socket and the chip or between the chip socket and the circuit board.

In a feasible implementation, a holder is disposed on a side that is of the circuit board and that is away from the second clamping member, so that the circuit board is locked between the holder and the second clamping member by using the second fastener. This further improves rigidity of the circuit board, and reduces a deformation amount of the circuit board in the chip assembly, thereby further ensuring that force distribution of the chip terminals is more even. In addition, the chip and the chip socket are limited in the mounting opening of the holder, so as to improve stability of the chip and the chip socket in a horizontal direction, and further ensure good contact between the chip and the chip terminals.

In a feasible implementation, chip terminals are provided on two sides that are of the chip socket and that are opposite to each other along a thickness direction of the chip socket, and two sides of the chip socket are in electrical contact with both the chip and the circuit board through the chip terminals, that is, the chip socket having contacts on two sides is used to implement electrical conduction between the chip and the circuit board, thereby simplifying a structure of an electrical connection between the chip and the circuit board and improving electrical connection efficiency. In addition, the second clamping member is disposed to have the foregoing structure. In this way, force distribution of the chip terminals at both ends of the chip socket is more even, and stability of an electrical connection between the chip and the circuit board is ensured.

According to another aspect, an embodiment of this application provides a chip assembly. At least one first fastener is disposed in the first-direction extension area or the second-direction extension area of the chip. Compared with the conventional technology in which first fasteners are disposed at four corners on a periphery of the chip, distances between some of the first fasteners and a center line of the chip layout area are reduced. This ensures that some first fasteners are disposed close to the center line of the chip layout area, improves an effect of fastening the chip assembly by the first fastener and improving rigidity of the chip assembly, thereby ensuring deformation amounts of the circuit board, the first clamping member, the second clamping member, and the like, improving evenness of force distribution of the chip socket, and ensuring good electrical contact between two sides of the chip socket and the chip or between the chip socket and the circuit board.

In a feasible implementation, at least one first fastener is disposed in the first-direction extension area on two sides of the chip, or at least one first fastener may be disposed in the second-direction extension areas on two sides of the chip, so as to improve symmetry of loading points of the chip assembly, and further disperse the centralized load. This improves an overall effect of locking the first clamping member and the second clamping member, improves rigidity of the chip assembly, and reduces deformation amounts of the circuit board, the first clamping member, the second clamping member, and the like, thereby improving evenness of force distribution of the chip socket, and ensuring good electrical contact between two sides of the chip socket and the chip or between the chip socket and the circuit board.

In a feasible implementation, at least four first fasteners may be evenly distributed on a periphery of the chip layout area, and are spaced from the first-direction extension area and the second-direction extension area of the chip. In addition, the first fasteners are disposed in the first-direction extension area or the second-direction extension area. That is, load support points are evenly distributed at the four corners on the periphery of the chip, and load support points are added in the extension area of the chip, so as to disperse centralized load; and spacings between the load support points of the chip assembly are also reduced. This improves an effect of fastening the chip assembly by the first fasteners, improves rigidity of the chip assembly, and reduces deformation amounts of the circuit board, the first clamping member, the second clamping member, and the like, thereby improving evenness of force distribution of the chip socket, and ensuring good electrical contact between two sides of the chip socket and the chip or between the chip socket and the circuit board.

In a feasible implementation, at least four first fasteners may be all disposed in extension areas of the chip in two directions, and are disposed around the chip. In this way, an overall effect of locking the first clamping member and the second clamping member is improved, and spacings between the first fasteners are correspondingly reduced, that is, spacings between load support points of the chip assembly are reduced. This improves rigidity of the chip assembly, reduces deformation amounts of the circuit board, the first clamping member, the second clamping member, and the like, thereby improving evenness of force distribution of the chip socket, and ensuring good electrical contact between two sides of the chip socket and the chip or between the chip socket and the circuit board.

According to still another aspect, an embodiment of this application further provides an electronic device, including at least one of the foregoing chip assemblies.

In this embodiment of this application, the chip assembly of the foregoing structure is disposed in the electronic device, so that a stable electrical connection between an internal chip and a circuit board can be implemented, thereby ensuring normal operation of the chip, avoiding a problem that the circuit board is damaged due to stress concentration, and prolonging a service life of the entire chip assembly.

### BRIEF DESCRIPTION OF DRAWINGS

FIG. 1 is a top view of a conventional chip assembly;
FIG. 2 is an assembly diagram of a chip assembly according to an embodiment of this application;
FIG. 3 is an exploded structural view of FIG. 2;
FIG. 4 is a schematic diagram of a structure of a chip socket in FIG. 3;
FIG. 5 is a top view of another chip assembly according to an embodiment of this application;
FIG. 6 is an exploded structural view of a second clamping member in FIG. 2;
FIG. 7 is a longitudinal sectional view of FIG. 2;
FIG. 8 is another assembly diagram of a chip assembly according to an embodiment of this application;
FIG. 9 is a longitudinal sectional view of FIG. 8;
FIG. 10 is an effect diagram of force distribution of a chip socket in a chip assembly according to an embodiment of this application;
FIG. 11 is an equivalent principle diagram of force distribution of the second clamping member in FIG. 5;
FIG. 12 is a top view of still another chip assembly according to an embodiment of this application;
FIG. 13 is an equivalent principle diagram of force distribution of the second clamping member in FIG. 12;
FIG. 14 is a top view of still another chip assembly according to an embodiment of this application;
FIG. 15 is an equivalent principle diagram of force distribution of the second clamping member in FIG. 14;
FIG. 16 is a top view of still another chip assembly according to an embodiment of this application;
FIG. 17 is a top view of still another chip assembly according to an embodiment of this application;
FIG. 18 is an equivalent principle diagram of force distribution of the second clamping member in FIG. 17;
FIG. 19 is an assembly diagram of still another chip assembly according to an embodiment of this application;
FIG. 20 is an exploded structural view of FIG. 19;
FIG. 21 is a schematic diagram of a structure of a second clamping member in FIG. 20;
FIG. 22 is a longitudinal sectional view of FIG. 19;
FIG. 23 is another assembly diagram of still another chip assembly according to an embodiment of this application; and
FIG. 24 is a longitudinal sectional view of FIG. 23.

### Descriptions of reference numerals:

100-First clamping member; 200-Chip; 300-Chip socket; 1, 400-Circuit board; 2-Heat sink; 3-Fastening screw; 500-Second clamping member; 600-First fastener; 700-Holder; 800-Second screw; 900-Nut;
21, 210-Chip layout area; 22, 220-First-direction extension area; 23, 230-Second-direction extension area; 310-Chip terminal; 320-Stop portion; 410-Screw hole; 510-Upper clamping member; 520-Lower clamping member; 530-Middle member; 540-Curved surface; 550-Avoidance groove; 560-Second stiffener; 610-First screw; 620-Screw cap; 630-Elastic member; 710-Mounting opening;
511-Avoidance hole; 512-First stiffener.

### DESCRIPTION OF EMBODIMENTS

Terms used in embodiments of this application are only used to explain specific embodiments of this application, but are not intended to limit this application.

As a size of a chip continuously increases (a length of a single side of a chip is currently greater than 80 mm), it is increasingly difficult for a conventional chip to be directly soldered on a circuit board in a ball grid array package (Ball Grid Array Package, BGA for short) manner. Therefore, it has become a trend to assemble a chip by using a socket solution, that is, a chip socket solution. A chip substrate is also referred to as a chip socket in actual application.

A CPU socket circuit system is used as an example. As shown in FIG. 1, a conventional chip assembly includes a heat sink 2, a chip, a chip socket, a circuit board 1, and a backplane that are sequentially stacked, where the heat sink 2 is configured to dissipate heat for the chip, to ensure that the chip is in a proper temperature range, so as to prolong a service life of the chip. The chip is electrically connected to the circuit board 1 through the chip socket, so as to implement signal transmission between the chip and the circuit board 1. In addition, the circuit board 1 may supply power to the chip, and the backplane is configured to bear the circuit board 1.

In actual application, the chip socket is a connector, and includes a plastic body and a chip terminal. A groove is disposed on the plastic body, and the chip terminal is fixed in the groove. Chip sockets can be classified into chip sockets having contacts on a single side and chip sockets having contacts on two sides according to classification of terminal contacts. The chip terminal is generally a metal terminal.

The chip socket having contacts on a single side further includes solder balls. The solder balls and the chip terminals are respectively disposed on two end surfaces that are of the chip socket and that are disposed opposite to each other. For example, a plurality of chip terminals are disposed on one side surface of the chip socket, and a plurality of solder balls are disposed on the other side surface. When the chip is connected to the circuit board 1 by using the chip socket, the chip is in contact with the chip terminal, to implement an electrical connection between the chip and the chip socket. Another side surface of the chip socket is soldered to the circuit board 1 by using a solder ball, to implement an electrical connection between the chip socket and the circuit board 1, thereby implementing electrical conduction between the chip and the circuit board 1. Certainly, when the chip socket is a chip socket having contacts on a single side, the chip terminals on one side of the chip socket may be in contact with the circuit board 1, so as to implement an electrical connection between the circuit board 1 and the chip socket; and the other side of the chip socket is soldered on the chip by using solder balls, so as to implement an electrical connection between the chip socket and the chip. The following specifically uses an example in which a chip is in contact with a chip terminal of a chip socket for description.

A plurality of chip terminals are provided on two sides of the chip socket having contacts on two sides. When the chip is electrically connected to the circuit board 1 through the chip socket, the chip and the circuit board 1 are respectively in contact with the chip terminals on two sides of the chip socket, so as to implement electrical conduction between the chip and the circuit board 1.

The chip socket having contacts on two sides is used as an example. In a CPU socket circuit system, to implement an electrical connection between the chip and the circuit board 1 by using the chip socket, the chip and the circuit board 1 are required to provide a specific clamping force for the chip terminals of the chip socket in the CPU socket system, and good contact between the chip and the chip socket and between the chip socket and the circuit board 1 is implemented through interaction forces between the chip terminals of the chip socket and the chip and the circuit board 1. Therefore, the greater the action force applied to the chip terminals of the chip socket, the better the contact.

To ensure that two sides of the chip socket are respectively in good contact with the chip and the circuit board 1, in the CPU socket circuit system, a heat sink 2 and a backplane are respectively used as an upper clamping member and a lower clamping member; the chip, the chip socket, and the circuit board 1 are clamped between the heat sink 2 and the backplane; and the entire CPU socket circuit system is locked by using fastening screws 3 that pass through the heat sink 2, the circuit board 1, and the backplane. In this way, the heat sink 2 has a clamping force towards the chip in the direction of the chip socket, and the backplane has a clamping force towards the circuit board 1 in the direction of the chip socket, so that the chip terminals on two sides of the chip socket are subject to a specific clamping force. Under the action of the clamping force, the chip terminals on two sides of the chip socket are respectively in stable contact with the chip and the circuit board 1.

The clamping force applied to the chip terminals of the chip socket is also referred to as a normal force, and the normal force is parallel to a mounting direction of the CPU socket circuit system. In other words, the normal force is perpendicular to a surface of the chip and a surface of the circuit board 1.

However, in a conventional chip assembly, there are usually four fastening screws 3, and the four fastening screws 3 are respectively arranged at four corners on a periphery of the chip. FIG. 1 is a top view of the conventional chip assembly. Refer to FIG. 1. For example, a heat sink 2 is generally of a quadrilateral structure, and four fastening screws 3 are respectively disposed at four corners of the heat sink 2. In this way, the four fastening screws 3 are just spaced from a first-direction extension area 22 and a second-direction extension area 23 of a chip.

Refer to FIG. 1. The first-direction extension area 22 of the chip is an extension area of a chip layout area 21 in a first direction (refer to a direction a in FIG. 1). In other words, the first-direction extension area 22 is an area where two sides that are of the chip layout area 21 and that are disposed opposite to each other along the direction a extend in the direction a. Correspondingly, the second-direction extension area 23 of the chip refers to an extension area of the chip layout area 21 in a second direction (refer to a direction b in FIG. 1). In other words, the second-direction extension area 22 is an area where two sides that are of the chip layout area 21 and that are disposed opposite to each other along the direction b extend in the direction b. The first direction is perpendicular to the second direction.

The chip layout area 21 is an orthographic projection area of the chip on each layer of components of the chip assembly along a height direction (that is, a stacking direction) of the chip assembly. For example, the orthographic projection area of the chip on the circuit board 1 is the chip layout area 21 on the circuit board 1, and the orthographic projection area of the chip on the heat sink 2 is the chip layout area 21 on the heat sink 2.

It may be understood that the first-direction extension area 22 of the chip includes two extension areas on two sides of the chip layout area 21 along the first direction, and the second-direction extension area 23 of the chip includes two extension areas on two sides of the chip layout area 21 along the second direction.

A chip of a rectangular structure is used as an example. The first direction may be a length direction of the chip, and the second direction may be a width direction of the chip. In this case, the first-direction extension area 22 is an area that extends the chip layout area 21 to left and right sides along the length direction, and the second-direction extension area 23 is an area that extends the chip layout area 21 to upper and lower sides along the width direction.

After the fastening screws 3 lock the components at each layer, that is, after the CPU socket circuit system is assembled, because of layout positions of the fastening screws 3 and rigidity of the heat sink 2, the circuit board 1, and the backplane, the heat sink 2 on the chip side may easily protrude in a direction away from the chip, and the circuit board 1 and the backplane on the side of the circuit board 1 may easily concave in a direction away from the chip. In other words, the heat sink 2 on the chip side, the circuit board 1, and the backplane on the side of the chip socket bend in a direction away from the center of the chip assembly. In this way, it is inevitable that the circuit board 1 or the chip is not press-fit on the chip terminal of the chip socket, that is, a gap is generated between the chip and the chip socket or between the chip socket and the circuit board 1, so that a normal force on the chip terminal on one side of the chip socket is zero. Alternatively, a clamping force, that is, a normal force, of the circuit board 1 or the chip on the chip terminal of the chip socket is excessively small, which affects reliability of contact between the chip and the chip terminals of the chip socket or between the circuit board 1 and the chip terminals of the chip socket, and affects stability of an electrical connection between the chip and the circuit board 1.

It should be noted that, when the chip socket is a chip socket having contacts on a single side, after the CPU socket circuit system is assembled, the heat sink 2 on the chip side may easily protrude in a direction away from the chip, and the circuit board 1, together with the chip socket and a backplane on the side of the circuit board 1, may easily concave in a direction away from the chip. In this way, a gap is formed between the chip and the chip terminal of the chip socket, or a clamping force of the chip on the chip terminal of the chip socket is reduced, thereby affecting reliability of contact between the chip and the chip terminals of the chip socket, and further affecting reliability of an electrical connection between the chip and the circuit board 1.

Based on this, embodiments of this application provide an electronic device and a chip assembly. A protruding structure is designed in a clamping member on a side that is of a circuit board and that is away from a chip, and the protruding structure extends in a direction towards the chip, so as to support the circuit board, that is, to provide a specific support force for the circuit board, thereby ensuring close contact between the chip and a chip socket or between the chip socket and the circuit board, and implementing a stable electrical connection between the chip and the circuit board.

The following describes in detail the electronic device and the chip assembly in the embodiments of this application by using a plurality of embodiments.

### Embodiment 1

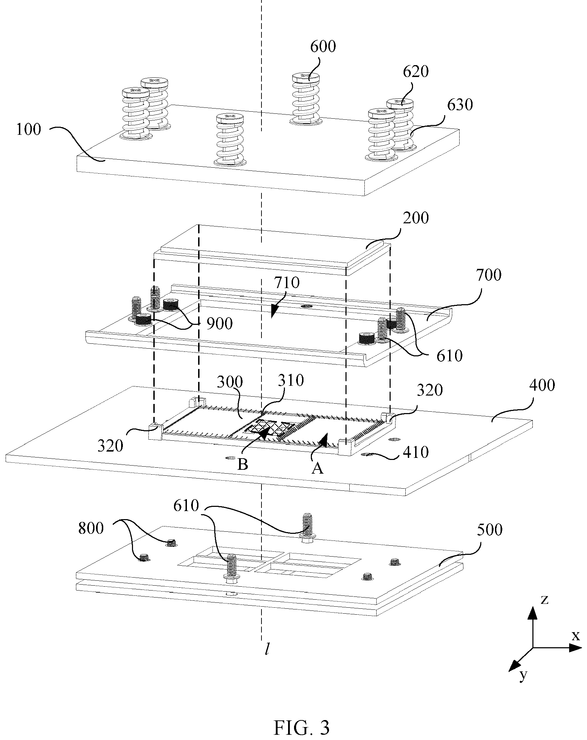

FIG. 2 is an assembly diagram of a chip assembly according to this embodiment; and FIG. 3 is an exploded structural view of FIG. 2. Refer to FIG. 2 and FIG. 3. An embodiment of this application provides a chip assembly, including a first clamping member 100, a chip 200, a chip socket 300, a circuit board 400, and a second clamping member 500 that are sequentially stacked. The chip 200 is electrically connected to the circuit board 400 through the chip socket 300, and at least one side of the chip socket 300 is in electrical contact with the chip 200 or the circuit board 400.

For ease of description, a direction z in FIG. 3 is used as an assembly direction and a height direction of the chip assembly in this embodiment of this application, a direction x is used as a length direction of the chip assembly in this embodiment of this application, and a direction y is used as a width direction of the chip assembly in this embodiment of this application.

Refer to FIG. 3. The first clamping member 100, the chip 200, the chip socket 300, the circuit board 400, and the second clamping member 500 are sequentially disposed from top to bottom along the direction z of the chip assembly in this embodiment of this application. In other words, the chip assembly formed by the chip 200, the chip socket 300, and the circuit board 400 is clamped between the first clamping member 100 and the second clamping member 500.

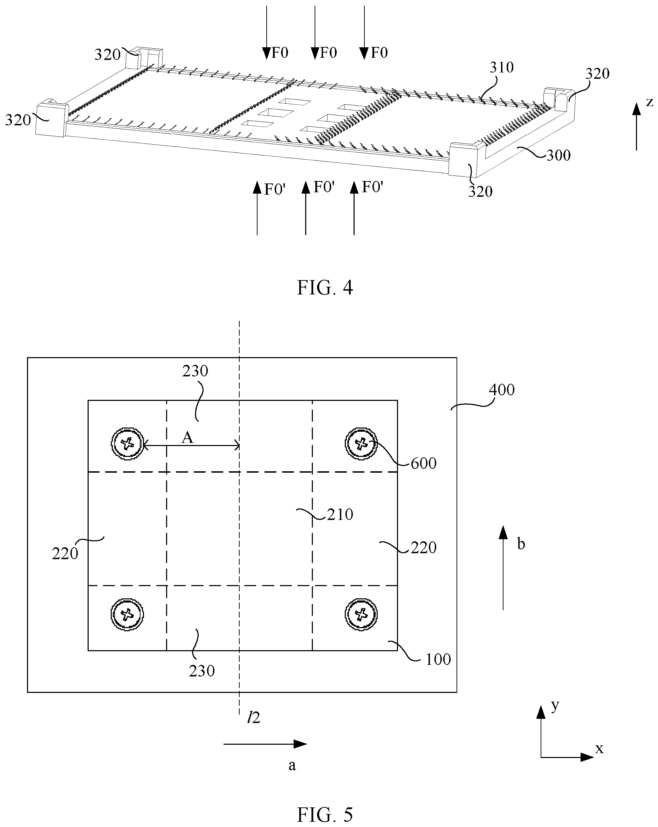

FIG. 4 is a schematic diagram of a structure of the chip socket in FIG. 3. Refer to FIG. 4. The chip socket 300 in this embodiment of this application may be a chip socket in a conventional technology. For example, the chip socket 300 may be a chip socket 300 having contacts on a single side, that is, the chip socket 300 has two side end surfaces disposed opposite to each other in a thickness direction (refer to a direction z in FIG. 4), a plurality of chip terminals 310 are disposed at intervals one side of the chip socket 300, and a side that is of the chip socket 300 and that faces the chip 200 is in contact with the chip 200 by using the chip terminals 310, so as to implement an electrical connection between the chip 200 and the chip socket 300. A plurality of solder balls (not shown in the figure) are disposed at intervals on the other side end surface of the chip socket 300, that is, a side facing the circuit board 400, and a side that is of the chip socket 300 and that faces the circuit board 400 is soldered to the circuit board 400 by using the solder balls, to implement an electrical connection between the chip socket 300 and the circuit board 400, so as to implement conduction between the chip 200 and the circuit board 400.

It should be noted that, in actual application, the chip terminals 310 on the chip socket 300 are distributed at intervals on an entire side end surface of the chip socket 300. FIG. 4 shows only some of the chip terminals 310 that are located on the edge and the inner side of the side end surface of the chip socket 300, which is used as an example for description. For a structure and a layout manner of other chip terminals 310 on the end surface, directly refer to a chip socket in a related technology.

It may be understood that a thickness direction of the chip socket 300 is consistent with a height direction of the chip assembly.

When the chip socket 300 is a chip socket having contacts on two sides, a plurality of chip terminals 310 are disposed at intervals on two side end surfaces of the chip socket 300. The chip 200 is in contact with the chip terminals 310 on one side of the chip socket 300, to implement an electrical connection between the chip 200 and the chip socket 300; and the circuit board 400 is in contact with the chip terminals 310 on the other side of the chip socket 300, to implement an electrical connection between the circuit board 400 and the chip socket 300.

The circuit board 400 in this embodiment of this application may be a printed circuit board (Printed Circuit Board, PCB for short).

Refer to FIG. 2 and FIG. 3. The chip assembly in this embodiment of this application further includes a plurality of first fasteners 600. The plurality of first fasteners 600 are disposed around the chip 200 at intervals. The first fasteners 600 are configured to lock the first clamping member 100 and the second clamping member 500, so as to lock the entire chip assembly. For example, the plurality of first fasteners 600 may be penetrated into in the first clamping member 100 and the second clamping member 500, so as to clamp the chip assembly. Certainly, the plurality of first fasteners 600 may alternatively lock the first clamping member 100 and the second clamping member 500 in another manner. For example, the second clamping member 500, the circuit board 400, the chip socket 300, and the chip 200 may be locked together by using other components such as the holder 700 and the second fastener, and then the first fastener 600 is penetrated into the first clamping member 100 and the holder 700, so that the first clamping member 100 and the second clamping member 500 may be locked together. For details, refer to the following content about the holder 700.

FIG. 5 is a top view of another chip assembly according to an embodiment of this application. Refer to FIG. 5. For example, the chip assembly may have four first fasteners 600, and the four first fasteners 600 are disposed around the chip 200 at intervals on a periphery of a chip layout area 210. For example, when a cross-sectional shape of the first clamping member 100 along an x-y plane is a quadrilateral structure, the four first fasteners 600 are disposed at four corners of the first clamping member 100. In addition, the four first fasteners 600 may be penetrated into the first clamping member 100, the circuit board 400, and the second clamping member 500, so that the chip assembly is locked between the first clamping member 100 and the second clamping member 500. It may be understood that, in the foregoing example, for specific positions of the four first fasteners 600, directly refer to a conventional manner of disposing the fastening screws 3 in the chip assembly (as shown in FIG. 1). Details are not described herein again.

Refer to FIG. 5. The chip layout area 210 is an orthographic projection area of the chip 200 on each layer of components of the chip assembly in a direction z. For example, refer to FIG. 3. The orthographic projection area (refer to A in FIG. 3) of the chip 200 on the circuit board 400 is the chip layout area 210 of the circuit board 400, and the orthographic projection area of the chip 200 on the second clamping member 500 is also the chip layout area 210 of the second clamping member 500.

Refer to FIG. 3. The orthographic projection area A of the chip 200 on the upper surface of the circuit board 400 is located in the orthographic projection area of the chip socket 300 on the upper surface of the circuit board 400, so as to ensure that all pins in the chip 200 can be connected to the circuit board 400 by using the chip terminal 310 on the chip socket 300.

Refer to FIG. 5. The chip layout area 210 is in a middle area of each layer of mechanical parts in the chip assembly. For example, the middle area of the circuit board 400 is used for arranging the chip socket 300 and the chip 200 (refer to FIG. 3), and the middle area of the second clamping member 500 is also the chip layout area 210. It may be understood that, as shown in FIG. 3, a middle area of each layer of mechanical parts in the chip assembly, for example, the circuit board 400, is a part of an area that is of each layer of mechanical parts and through which an axis *l* passes. In other words, an axis of a middle area of each layer of mechanical parts in the chip assembly coincides with an axis *l* of the chip assembly.

When the chip assembly is in a locked state, that is, an assembled state, the first clamping member 100 transfers a clamping force (refer to F0 in FIG. 3) to the chip socket 300 by using the chip 200, and the second clamping member 500 transfers a clamping force (refer to F0' in FIG. 3) to the chip socket 300 by using the circuit board 400, so that the chip terminal 310 on the chip socket 300 is subject to a specific clamping force, and good contact between the chip 200 and the chip socket 300 or between the chip socket 300 and the circuit board 400 is implemented.

It should be noted that a clamping force applied to the chip terminals 310 of the chip socket 300 is also referred to as a normal force, and a direction of the normal force is parallel to the direction z.

Refer to FIG. 3 and FIG. 4. In actual application, four stop portions 320 are disposed on a side that is of the chip socket 300 and that faces the chip 200, and the four stop portions 320 are respectively disposed at four corners of the chip socket 300. The chip 200 is mounted on the chip socket 300, and four stop portions 320 are used to limit the chip 200 in a horizontal direction (in all directions in the x-y plane). This not only facilitates mounting and positioning of the chip 200, but also prevents the chip 200 from deviating from the surface of the chip socket 300, thereby ensuring good contact with the chip terminal 310.

The following describes a structure of a chip assembly by using an example in which the chip socket 300 is a chip socket having contacts on a single side.

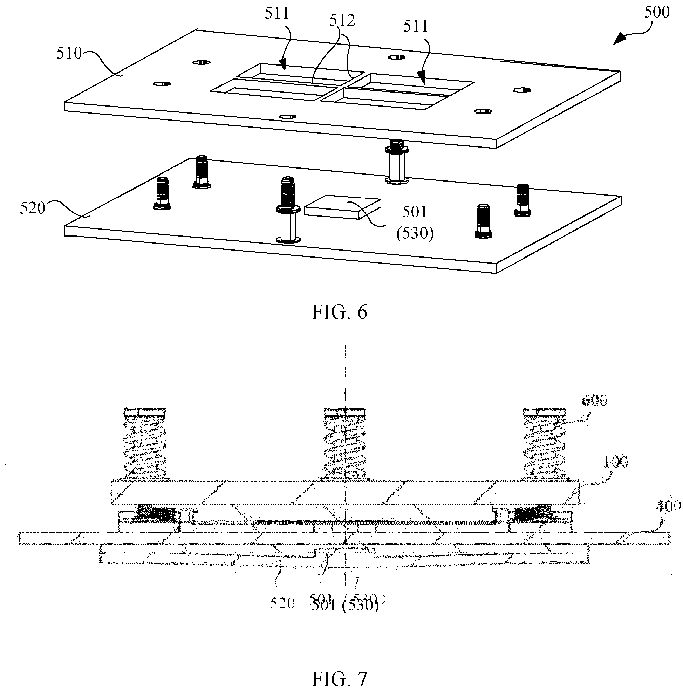

FIG. 6 is an exploded structural view of the second clamping member in FIG. 2; and FIG. 7 is a longitudinal sectional view of FIG. 2. Refer to FIG. 6 and FIG. 7. In this embodiment of this application, the second clamping member 500 has a protruding portion 501 extending in a direction of the first clamping member 100, and the protruding portion 501 is located in an area enclosed by all the first fasteners 600.

Refer to FIG. 7. None of the first fasteners 600 is disposed on the protruding portion 501.

It should be noted that an area enclosed by all the first fasteners 600 is an orthographic projection area, along the direction z, of a polygonal area enclosed by all the first fasteners 600 by sequentially connecting lines on each layer of components of the chip assembly. For example, there are four first fasteners 600, the four first fasteners 600 are arranged at intervals around the chip 200 on a periphery of the chip layout area 210, the four first fasteners 600 are sequentially connected to form a quadrilateral, the quadrilateral encloses a quadrilateral area, and the protruding portion 501 is located in an orthographic projection area of the quadrilateral area on the second clamping member 500 along the direction z.

In addition, at least a part of the protruding portion 501 in the orthographic projection area (refer to an area B in FIG. 3) on the circuit board 400 is located in an orthographic projection area (refer to an area A in FIG. 3) of the chip 200 on the circuit board 400, that is, the orthographic projection area of the protruding portion 501 on the circuit board 400 is located in the chip layout area 210 on the circuit board 400. It should be noted that the orthographic projection area of the protruding portion 501 on the circuit board 400 is specifically an orthographic projection area of the protruding portion 501 on the circuit board 400 along the direction z.

For example, a part of the orthographic projection area B that is of the protruding portion 501 and that is on the circuit board 400 is located in the orthographic projection area A (not shown in the figure) of the chip 200 on the circuit board 400. In other words, a part of the orthographic projection area B that is of the protruding portion 501 and that is on the circuit board 400 is located in the chip layout area 210, and the other part is located outside the chip layout area 210.

A chip socket 300 having contacts on a single side is used as an example. After the first fastener 600 locks the entire chip assembly, the circuit board 400 has a specific support force for the chip layout area 210 (that is, the area A) of the circuit board 400 under abutting of the protruding portion 501. The protruding portion 501 may support the chip layout area 210 of the circuit board 400, and may abut against the chip layout area 210 of the circuit board 400, that is, the middle area, to be in a horizontal state or protrude in a direction towards the chip 200. This prevents the circuit board 400 from bending downward, that is, from bending in a direction away from the chip 200, and avoids a gap between the chip socket 300 and the chip 200, so that force distribution of the chip terminals 310 on the chip socket 300 is more even, thereby ensuring good contact between the chip socket 300 and the chip 200, and further ensuring reliability of an electrical connection between the chip 200 and the circuit board 400.

Refer to FIG. 3. In some examples, the orthographic projection area B of the protruding portion 501 on the circuit board 400 is located in the orthographic projection area A of the chip 200 on the circuit board 400. In other words, the orthographic projection area B of the entire protruding portion 501 on the circuit board 400 is completely located in the orthographic projection area A of the chip 200 on the circuit board 400, that is, the chip layout area 210. In this way, the entire protruding portion 501 effectively supports the chip layout area 210 of the circuit board 400, so as to ensure close contact between the chip 200 and the chip socket 300.

It may be understood that, when the chip socket 300 is a chip socket 300 having contacts on two sides, that is, chip terminals 310 are disposed on two sides that are of the chip socket 300 and that are opposite to each other in a thickness direction of the chip socket 300, and two sides of the chip socket 300 are respectively in electrical contact with the chip 200 and the circuit board 400 by using the chip terminals 310. That is, the chip socket 300 having contacts on two sides is used to implement electrical conduction between the chip 200 and the circuit board 400, thereby simplifying an electrical connection structure between the chip 200 and the circuit board 400, and improving the electrical connection efficiency.

In addition, the second clamping member 500 is disposed to have the foregoing structure, so that force distribution of the chip terminals 310 at the two ends of the chip socket 300 is more even. For example, the protruding portion 501 effectively supports the chip layout area 210 of the circuit board 400, so that force distribution of the chip terminals 310 on a side that is of the chip socket 300 and that faces the circuit board 400 is more even, thereby improving close contact between the chip socket 300 and the circuit board 400. In addition, the protruding portion 501 abuts against the chip layout area 210 of the circuit board 400, so that force distribution of the chip terminal 310 on a side that is of the chip socket 300 and that faces the chip 200 is more even, thereby ensuring close contact between the chip socket 300 and the chip 200, and further improving stability of an electrical connection between the chip and the circuit board.

The following describes in detail the second clamping member 500 of different structures by using Embodiment 1 and Embodiment 2.

### Embodiment 1

Refer to FIG. 6. The second clamping member 500 in this embodiment of this application includes an upper clamping member 510, a lower clamping member 520, and a middle member 530 located between the upper clamping member 510 and the lower clamping member 520. The upper clamping member 510 is located on a side surface of the circuit board 400, that is, the upper clamping member 510 is located on a side surface that is of the circuit board 400 and that is away from the chip socket 300, the lower clamping member 520 is disposed opposite to the upper clamping member 510, and the middle member 530 is clamped between the lower clamping member 520 and the upper clamping member 510, where the middle member 530 is located in an area enclosed by all the first fasteners 600. For example, the middle member 530 is located in an orthographic projection area that is of a quadrilateral area enclosed by the four first fasteners 600 and that is on the second clamping member 500 along a direction z.

In this embodiment of this application, the middle member 530 is configured as a protruding portion 501 of the second clamping member 500. In other words, the middle member 530 is used as the protruding portion 501 formed on the second clamping member 500.

Refer to FIG. 6. For example, an outer contour size of the middle member 530 is less than an outer contour size of the upper clamping member 510 and an outer contour size of the lower clamping member 520, and all first fasteners 600 may be penetrated into the lower clamping member 520 and the upper clamping member 510, and are not penetrated into the middle member 530.

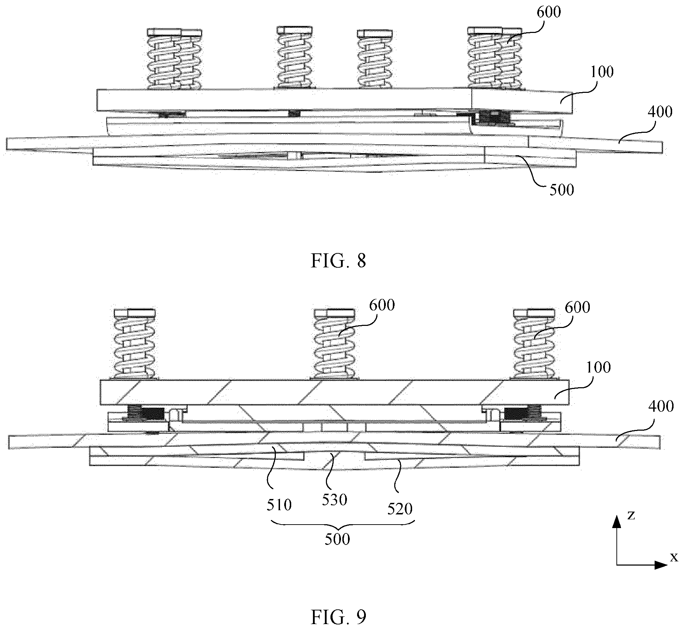

FIG. 8 is another assembly diagram of a chip assembly according to an embodiment of this application; and FIG. 9 is a longitudinal sectional view of FIG. 8.

Refer to FIG. 7 to FIG. 9. A chip socket 300 having contacts on a single side is used as an example. After first fasteners 600 lock the entire chip assembly, a lower clamping member 520 is subject to an action force in a direction towards a chip 200, and the action force is transferred to an upper clamping member 510 through a middle member 530. In this way, the upper clamping member 510 has a specific support force for a chip layout area 210 of a circuit board 400 under abutting of the middle member 530. In other words, the middle member 530 abuts against the upper clamping member 510, to support the chip layout area 210 of the circuit board 400.

Specifically, due to rigidity of the lower clamping member 520, locking forces of the first fasteners 600, and the like, the circuit board 400 presents the following several locked states under clamping of the second clamping member 500.

Refer to FIG. 7. As a locked state, after the first fastener 600 locks the chip assembly, the middle area of the lower clamping member 520 bends in a direction away from the chip 200, and the middle member 530 moves downward for a specific distance when transferring the action force applied to the lower clamping member 520 to the chip layout area 210 of the upper clamping member 510, so that the middle member 530 abuts against the middle area of the upper clamping member 510 to slightly protrude upward, the slightly protruding upper clamping member 510 abuts against the chip layout area 210, that is, the middle area, of the circuit board 400 to a horizontal state. This prevents the circuit board 400 from bending downward, that is, from bending in a direction away from the chip 200, and avoids a gap between the chip socket 300 and the chip 200, so that force distribution of the chip terminals 310 on the chip socket 300 is more even, thereby ensuring good contact between the chip socket 300 and the chip 200, and further ensuring reliability of an electrical connection between the chip 200 and the circuit board 400.

Refer to FIG. 8. As another locked state, after the first fastener 600 locks the chip assembly, the middle area of the lower clamping member 520 bends in a direction away from the chip 200. In addition, when transferring an action force to the upper clamping member 510, the middle member 530 abuts against the middle area of the upper clamping member 510 to bend upward, the upper clamping member 510 that bends upward abuts against the chip layout area 210 (that is, the middle area) of the circuit board 400, to bend upward, that is, to bend in a direction towards the chip 200. This further avoids a gap between the chip socket 300 and the chip 200, so that force distribution of the chip terminal 310 on the chip socket 300 is more even, thereby ensuring good contact between the chip socket 300 and the chip 200, and further ensuring reliability of an electrical connection between the chip 200 and the circuit board 400.

Certainly, another locked state is not excluded in this embodiment of this application, and a locked state of the chip assembly in this embodiment of this application is not limited herein, provided that it is ensured that the chip layout area 210 of the circuit board 400 has a specific clamping force on two sides of the chip socket 300 under the support of the second clamping member 500, so as to ensure that force distribution of the chip terminals 310 on the chip socket 300 is more even, and ensure that electrical contact between the chip socket 300 and the chip 200 is more reliable.

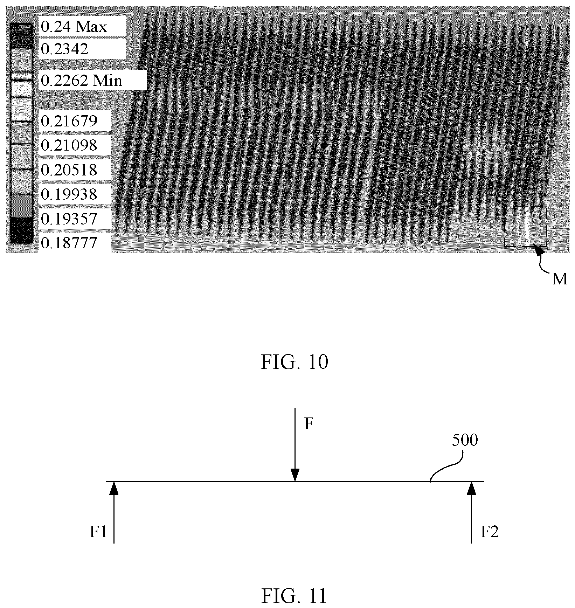

FIG. 10 is an effect diagram of force distribution of a chip socket in a chip assembly according to an embodiment of this application. Refer to FIG. 10. An area M represents a normal force applied to chip terminals that are of a chip socket 300 and that are located in a central area in a chip assembly in an embodiment of this application. It can be learned that a minimum normal force applied to the chip terminals that are of the chip socket 300 and that are located in the central area is 0.2262 N, which can ensure reliability of an electrical connection between a chip 200 and a circuit board 400.

In this embodiment of this application, an outer edge of the upper clamping member 510 may be located on a periphery of an area enclosed by all loading points of the first fasteners 600. For example, the first fastener 600 may be penetrated into the upper clamping member 510 and the lower clamping member 520, and does not pass through the middle member 530. In this way, the middle member 530 transfers an action force to the circuit board 400 through the upper clamping member 510. This ensures continuity of an action force between each position of the upper clamping member 510 inside the loading point and the circuit board 400, and avoids stress concentration on the circuit board 400, thereby ensuring the circuit board 400 is not damaged, and prolonging a service life of the chip assembly.

It may be understood that, when the chip socket 300 is a chip socket having contacts on a single side, solder balls on the chip socket 300 are soldered on the circuit board 400, and a chip terminal on the chip socket 300 is in electrical contact with the chip 200, the chip assembly in this embodiment of this application reduces a pulling force generated on solder joints of the solder balls when the circuit board bends in a direction away from the chip 200, thereby avoiding damage or even fracture of the solder joint between the solder balls and the circuit board 400, and ensuring soldering stability between the chip socket 300 and the circuit board 400. Two sides of the chip socket 300 in this embodiment of this application may be in electrical contact with the chip 200 and the circuit board 400 by using the chip terminal 310. That is, the chip socket 300 having contacts on two sides is used to implement electrical conduction between the chip 200 and the circuit board 400, thereby simplifying an electrical connection structure between the chip 200 and the circuit board 400, and improving electrical connection efficiency. In addition, the second clamping member 500 is disposed to have the foregoing structure, so that force distribution of the chip terminals 310 on two sides of the chip socket 300 is more even, and contact between the chip terminals 310 on two sides of the chip socket 300 and the chip 200 and the circuit board 400 is more reliable, thereby ensuring stability of an electrical connection between the chip 200 and the circuit board 400.

Refer to FIG. 7. During specific disposition, at least a part of the middle member 530 is disposed on an axis *l* of the chip 200, so that the middle member 530 just applies, by using the upper clamping member 510, a force on an area that is of the chip 200 and that is corresponding to a center of the circuit board 400, thereby further improving close contact between two sides of the chip socket 300 and the circuit board 400 and the chip 200, and ensuring that force distribution of the chip terminal 310 is even. This ensures good electrical contact between the chip socket 300 and the chip 200 or between the chip socket 300 and the circuit board 400, thereby implementing a stable electrical connection between the chip 200 and the circuit board 400. For example, an axis of the middle member 530 may coincide with an axis *l* of the chip 200. This embodiment of this application is described in detail by using the axis of the chip 200 and the axis *l* of the chip assembly as an example.

Certainly, in some examples, an axis of the chip 200 may also deviate from an axis *l* of the chip assembly. This example is not excluded in this embodiment of this application.

Refer to FIG. 6. The second clamping member 500 in this embodiment of this application may be of a split structure. For example, the second clamping member 500 may include two mechanical parts. For example, the middle member 530 and the lower clamping member 520 may be disposed as an integral part that is integrally formed. In other words, the middle member 530 and the lower clamping member 520 are integrally formed. For example, a protruding structure is extended upward on a surface of the lower clamping member 520, and the protruding structure is used as the middle member 530 and is integrated with the lower clamping member 520.

In this embodiment of this application, the middle member 530 and the lower clamping member 520 are disposed as an integral part that is integrally formed, so that a structural strength of the middle member 530 and the lower clamping member 520 is improved, and a quantity of components of the second clamping member 500 is reduced, thereby simplifying a structure of the second clamping member 500, and improving manufacturing efficiency and assembly efficiency of the second clamping member 500.

As a switching rate and a computing capability of a chip increase, a requirement for current flowing of the chip and a requirement for a dynamic feature of the chip are increasingly high, and electronic components such as a power module, a resistor, and a filter capacitor that are disposed on the circuit board 400 gradually increase. Because the chip socket 300 is disposed on a side surface of the circuit board 400, an electronic component is generally disposed on a side (no electronic component is shown in the figure) that is of the circuit board 400 and that is away from the chip socket 300, that is, the electronic component is disposed on a side surface that is of the circuit board 400 and that faces the second clamping member 500.

Refer to FIG. 6. To prevent the second clamping member 500 from causing damage an electronic component in a process of assembling a chip assembly, in this embodiment of this application, an avoidance hole 511 is formed in a position that is on the upper clamping member 510 and that is corresponding to the electronic component. In this way, after the upper clamping member 510 is attached to the circuit board 400, the electronic component is just located in the avoidance hole 511. This ensures that the upper clamping member 510 is closely attached to the circuit board 400, avoids a case in which stress concentration occurs on the circuit board 400 due to a gap between the upper clamping member 510 and the circuit board 400, and avoids a case in which the upper clamping member 510 squeezes and causes damage to the electronic component, thereby ensuring normal operation of the electronic component.

It may be understood that a size and a shape of the avoidance hole 511 may match an electronic component on the circuit board 400. This not only implements a function of avoiding the electronic component, but also avoids a case in which a structural strength of the upper clamping member 510 is reduced because the avoidance hole 511 is excessively large.

Certainly, there may be one avoidance hole 511, and one avoidance hole 511 is configured to accommodate a plurality of electronic components.

In actual application, electronic components are generally centrally arranged in an orthographic projection area of the chip 200 on the circuit board 400, that is, the electronic components are disposed in the chip layout area 210 of the circuit board 400. To ensure that the middle area of the upper clamping member 510 can abut against the chip layout area 210 of the circuit board 400, in this embodiment of this application, a first stiffener 512 is disposed in the avoidance hole 511, and at least a part of the first stiffener 512 is in contact with the middle member 530, so as to ensure that the middle member 530 transfers an action force to the upper clamping member 510, and then transfers the action force to the chip layout area 210 of the circuit board 400 to support the chip layout area 210 of the circuit board 400, for example, under the support of the middle member 530, the chip layout area 210 of the circuit board 400 may be in a horizontal state or bend in a direction towards the chip 200, so as to ensure close contact between the chip socket 300 and the chip 200 and between the chip socket 300 and the circuit board 400.

In addition, the first stiffener 512 is disposed in the avoidance hole 511, which further reinforces a structure of the avoidance hole 511, and ensures structural stability of the avoidance hole 511 on the upper clamping member 510.

Still refer to FIG. 6. For example, an avoidance hole 511 of a rectangular structure is disposed in a middle area of the upper clamping member 510, and two crossed first stiffeners 512 are disposed in the avoidance hole 511. Two sides of one stiffener are respectively connected to a pair of opposite hole walls of the avoidance hole 511, and two sides of the other first stiffener 512 are respectively connected to another pair of opposite hole walls of the avoidance hole 511, the intersection of the two first stiffeners 512 is in contact with the middle member 530, so that the middle member 530 transfers an action force to the upper clamping member 510 and the chip layout area 210 of the circuit board 400 by using a part of the intersection of the two first stiffeners 512.

Certainly, in another example, a first stiffener 512 may be further disposed in the avoidance hole 511, two sides of the first stiffener 512 may extend to any pair of opposite hole walls in the avoidance hole 511, and a part of the first stiffener 512 is in contact with the middle member 530. A quantity and a position of the first stiffener 512 are not specifically limited in this embodiment of this application, provided that it is ensured that a part of the first stiffener 512 is in contact with the middle member 530.

Refer to FIG. 2 and FIG. 3. In the chip assembly in this embodiment of this application, the first clamping member 100 may be a heat sink. The heat sink is disposed on one side of the chip 200, to provide a clamping function for the chip 200, and dissipate heat for the chip 200, so as to ensure that the chip 200 works normally.

In some examples, the first clamping member 100 may alternatively be a heat sink and an upper cover. The heat sink is located on a side surface of the chip 200; and the upper cover is disposed on a side that is of the heat sink and that is away from the chip 200, to protect the heat sink from being damaged. In addition, the heat sink and the upper cover are used together as the first clamping member 100 to provide a downward clamping force for the chip 200, so that the chip 200 is in close contact with the chip terminal 310 of the chip socket 300. A specific structure of the first clamping member 100 is not specifically limited in this embodiment of this application, provided that it is ensured that a clamping force in a direction towards the chip socket 300 can be provided for the chip 200.

Refer to FIG. 6 and FIG. 7. The second clamping member 500 in this embodiment of this application may be a plate-like member. The plate-like member may be a backplane of a chip assembly. For example, the plate-like member includes a first plate-like member, a second plate-like member, and a middle portion, where the middle portion is located between the first plate-like member and the second plate-like member, and the first plate-like member is located on a side surface of the circuit board 400.

The first fastener 600 located in the plate-like member is penetrated into the first plate-like member and the second plate-like member, a middle portion is located in an area enclosed by all the first fasteners 600, and an orthographic projection area of the middle portion on the circuit board 400 is located in an orthographic projection area of the chip 200 on the circuit board 400.

It may be understood that the first plate-like member is used as the upper clamping member 510 of the second clamping member 500, the middle portion is used as the middle member 530 of the second clamping member 500, and the second plate-like member is used as the lower clamping member 520 of the second clamping member 500.

After the first fastener 600 locks the entire chip assembly, the second plate-like member is subject to a clamping force in a direction towards the chip 200, and the clamping force is transferred to the first plate-like member through the middle portion. Then, the first plate-like member abut against, under abutting of the middle portion, an area in which the chip 200 is disposed on the circuit board 400, that is, the chip layout area 210 to be in a horizontal state or bend in a direction towards the chip 200.

In this embodiment of this application, the second clamping member 500 is disposed as a plate-like member, for example, a backplane, so that the plate-like member can not only be used for packaging the chip 200, but also avoid damage caused by stress concentration on the circuit board 400, thereby simplifying the chip assembly.

The plurality of first fasteners 600 in this embodiment of this application may be laid out in a plurality of manners.

Refer to FIG. 5. In a first layout manner (as mentioned above), there are four first fasteners 600, and the four first fasteners 600 are disposed around the chip 200 at intervals on a periphery of the chip layout area 210. For example, when the cross-sectional shape of the first clamping member 100 along the x-y plane is a quadrilateral structure, the four first fasteners 600 are disposed at four corners of the first clamping member 100, so that the four first fasteners 600 are just spaced from the first-direction extension area 220 and the second-direction extension area 230 of the chip 200.

Refer to FIG. 5. The first-direction extension area 220 of the chip 200 is an extension area of the chip layout area 210 in a first direction (refer to a direction a shown in FIG. 5). In other words, the first-direction extension area 220 is an area where two sides that are of the chip layout area 210 and that are disposed opposite to each other along the direction a extend in the direction a. Correspondingly, the second-direction extension area 230 of the chip 200 refers to an extension area of the chip layout area 210 in a second direction (refer to a direction b in FIG. 5). In other words, the second-direction extension area 230 is an area where two sides that are of the chip layout area 210 and that are disposed opposite to each other along the direction b extend in the direction b. The first direction is perpendicular to the second direction.

It may be understood that the first-direction extension area 220 of the chip 200 includes two extension areas on two sides of the chip layout area 210 along the first direction, and the second-direction extension area 230 of the chip 200 includes two extension areas on two sides of the chip layout area 210 along the second direction.

A chip 200 of a rectangular structure is used as an example. The first direction may be a length direction of the chip 200, and the second direction may be a width direction of the chip 200. In this case, the first-direction extension area 220 is an area that extends the chip layout area 210 to left and right sides along the length direction, and the second-direction extension area 230 is an area that extends the chip layout area 210 to upper and lower sides along the width direction.

This embodiment of this application is specifically described by using an example in which the direction x in FIG. 5 is used as the first direction, and the direction y is used as the second direction. Refer to FIG. 5. A distance between any first fastener 600 and a vertical center line *l*2 of the chip layout area 210 is A.

It should be noted that the vertical center line *l*2 of the chip layout area 210 is a symmetric center line of the chip layout area 210 in the first direction (refer to the direction x), and the vertical center line *l*2 is located in the x-y plane.

FIG. 11 is an equivalent principle diagram of force distribution of the second clamping member in FIG. 5. Refer to FIG. 11. In a first layout manner, action forces that are applied to the second clamping member 500 by the loading points of two pairs of first fasteners 600 disposed in the first direction may be equivalent to F1 and F2, and an action force that is applied to the second clamping member 500 by the chip socket 300 may be equivalent to F applied to a middle position of the second clamping member 500.

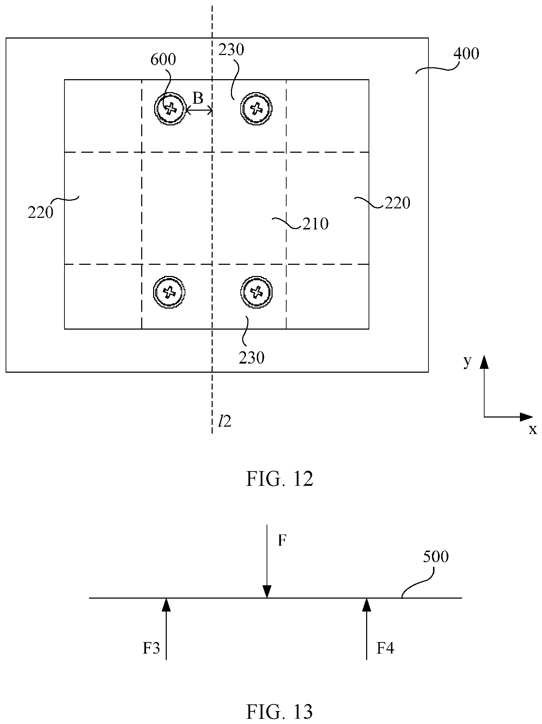

FIG. 12 is a top view of still another chip assembly according to an embodiment of this application. Refer to FIG. 12. In a second layout manner, in the plurality of first fasteners 600 in this embodiment of this application, at least one first fastener 600 is disposed in the first-direction extension area 220 or the second-direction extension area 230 of the chip 200.

It may be understood that the second layout manner includes the following several examples.

In a first example, all the first fasteners 600 are disposed in the extension area of the chip 200. For example, all the first fasteners 600 are disposed in the first-direction extension area 220 or the second-direction extension area 230, or all the first fasteners 600 are respectively disposed in the first-direction extension area 220 and the second-direction extension area 230.

In a second example, some first fasteners 600 are disposed outside the extension area of the chip 200. In other words, some first fasteners 600 are disposed outside the first-direction extension area 220 and the second-direction extension area 230, and other first fasteners 600 are disposed in the extension area of the chip 200, for example, other first fasteners 600 are disposed in the first-direction extension area 220 and the second-direction extension area 230 of the chip 200.

The following first describes the first example.

For example, at least two first fasteners 600 are all disposed in the first-direction extension area 220 of the chip 200, and at least two first fasteners 600 are respectively located on two sides of the chip layout area 210 along the first direction; or at least two first fasteners 600 are all disposed in the second-direction extension area 230 of the chip 200, and the at least two first fasteners 600 are respectively located on two sides of the chip layout area 210 along the second direction, where the first direction and the second direction are perpendicular to each other.

It may be understood that the foregoing example includes two cases: In the first case, all the first fasteners 600 may be disposed in the first-direction extension area 220 of the chip 200, or may be all disposed in the second-direction extension area 230 of the chip 200; in the second case, all the first fasteners 600 are respectively disposed in both the first-direction extension area 220 and the second-direction extension area 230 of the chip 200.

First, the first case is analyzed.

Refer to FIG. 12. For example, there are four first fasteners 600, and all the four first fasteners 600 are located in the second-direction extension area 230 of the chip 200, where two of the first fasteners 600 are disposed at intervals in the second-direction extension area 230 above the chip layout area 210, and the other two first fasteners 600 are disposed at intervals in the second-direction extension area 230 below the chip layout area 210. In addition, the two first fasteners 600 disposed at an interval along the first direction are respectively located on two sides of the vertical center line *l*2 of the chip layout area 210.

A vertical distance between any first fastener 600 in the second-direction extension area 230 and the vertical center line *l*2 is B. It can be easily learned that B is less than A.

In actual application, in the foregoing example, assuming that a distance between the two first fasteners 600 that are disposed at an interval along the first direction is L, a distance B between one of the first fasteners 600 and the vertical center line *l*2 is generally greater than or equal to L/4, to further improve evenness of force distribution of the chip socket 300.

FIG. 13 is an equivalent principle diagram of force distribution of the second clamping member in FIG. 12. Refer to FIG. 13. The second clamping member 500 is equivalent to a rod member. In the foregoing example, action forces that are applied to the second clamping member 500 by the loading points of two pairs of first fasteners 600 disposed in the first direction may be equivalent to F3 and F4, and an action force that is applied to the second clamping member 500 by the chip socket 300 may be equivalent to F applied to a middle position of the second clamping member 500.

It can be learned from basic knowledge of material mechanics that, compared with a manner in which two pairs of first fasteners 600 are disposed at four corners of the first clamping member 100, the manner in which at least two pairs of first fasteners 600 are all disposed in the second-direction extension area 230 of the chip 200 reduces distances between the first fasteners 600 and the center line (for example, the vertical center line 12) of the chip layout area 210, and reduces distances between loading points of the two pairs of first fasteners 600 disposed in the first direction, that is, load support points of the chip assembly. Therefore, a deflection (that is, a deformation amount) generated by the second clamping member 500 in this example is far less than that generated by the second clamping member 500 in the first layout manner.

It may be understood that, in this embodiment of this application, the distance between the first fastener 600 in the second-direction extension area 230 and the vertical center line *l*2 of the chip layout area 210 is specifically used as a reference. Certainly, when there is a first fastener 600 in the first-direction extension area 220, a distance between the first fastener 600 in the first-direction extension area 220 and a horizontal center line of the chip layout area 210 may also be used as a reference.

The horizontal center line of the chip layout area 210 is a symmetric center line of the chip layout area 210 in a second direction (refer to a direction y in FIG. 12), and the vertical center line *l*2 is located in the x-y plane.

In actual application, at least two first fasteners 600 are located on two sides of the vertical center line 12, or at least two first fasteners 600 are located on two sides of the horizontal center line, so that there are load support points on two sides of the center line of the chip layout area 210, thereby further improving evenness of force distribution of the central position of the chip socket 300.

It may be understood that there may be six first fasteners 600, the six first fasteners 600 are all disposed in the second-direction extension area 230 of the chip 200, and every three first fasteners 600 are respectively disposed on the upper side and lower side of the chip layout area 210 in the second direction, so as to further improve structural stability of the chip assembly, reduce deformation amounts of the first clamping member 100, the second clamping member 500, the circuit board 400, and the like, thereby ensuring reliability of contact between two sides of the chip socket 300 and the chip 200 and the circuit board 400.

Certainly, in some examples, a quantity of first fasteners 600 in the second-direction extension areas 230 above the chip layout area 210 and a quantity of first fasteners in the second-direction extension areas 230 below the chip layout area 210 may be unequal. For example, two first fasteners 600 are disposed in the second-direction extension area 230 above the chip layout area 210, and one first fastener 600 is disposed in the second-direction extension area 230 below the chip layout area 210. The two first fasteners 600 in the second-direction extension area 230 above the chip layout area 210 may be respectively disposed on two sides of the vertical center line 12, and the first fasteners 600 in the second-direction extension area 230 below the chip layout area 210 may be disposed on the vertical center line *l*2 or near the vertical center line *l*2*.*

It can be learned from the foregoing descriptions that the at least two first fasteners 600 are disposed in the first-direction extension area 220 or the second-direction extension area 230 of the chip 200, and at least one first fastener 600 is respectively disposed on two sides of the chip layout area 210 along the first direction or on two sides of the chip layout area 210 along the second direction. Therefore, compared with the first layout manner, this manner reduces distances between some of the first fasteners 600 and the center line of the chip layout area 210 while ensuring an overall effect of locking the first clamping member 100 and the second clamping member 500, that is, the load support points of the chip assembly are disposed close to the center line of the chip layout area 210. This improves rigidity of the chip assembly, and reduces deformation amounts of the circuit board 400, the first clamping member 100, the second clamping member 500, and the like, thereby improving evenness of force distribution of the chip socket 300, and ensuring good electrical contact between two sides of the chip socket 300 and the chip 200 or between the chip socket 300 and the circuit board 400.

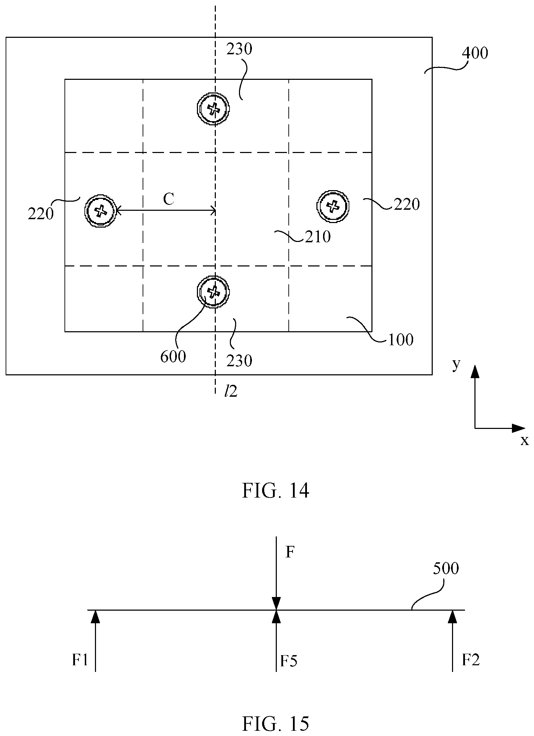

FIG. 14 is a top view of still another chip assembly according to an embodiment of this application. Refer to FIG. 14. In the second case of the first example, there may be at least four first fasteners 600, where at least two first fasteners 600 are all disposed in the first-direction extension area 220 of the chip 200, and the at least two first fasteners 600 are respectively located on two sides of the chip layout area 210 along the first direction; and at least two first fasteners 600 are all disposed in the second-direction extension area 230 of the chip 200, and the at least two first fasteners 600 are respectively located on two sides of the chip layout area 210 along the second direction.

For example, there are four first fasteners 600, and the four first fasteners 600 are all disposed in extension areas of the chip 200 in two directions, where the two first fasteners 600 are respectively disposed in two side extension areas of the chip layout area 210 along the first direction, that is, the left and right first-direction extension areas 220, and the other two first fasteners 600 are respectively disposed in two side extension areas of the chip layout area 210 along the second direction, that is, the upper and lower second-direction extension areas 230; and the first fasteners 600 located in the upper and lower second-direction extension areas 230 may be disposed on the vertical center line *l*2 of the chip layout area 210.

FIG. 15 is an equivalent principle diagram of force distribution of the second clamping member in FIG. 14. Refer to FIG. 15. In the second case of the first example, action forces applied to the second clamping member 500 by the left and right first fasteners 600 located in the first-direction extension area 220 may be equivalent to F1 and F2, action forces applied to the second clamping member 500 by the upper and lower first fasteners 600 located in the second-direction extension area 230 may be equivalent to F5, and action forces applied to the second clamping member 500 by the chip socket 300 may be equivalent to F applied to the middle position.

Refer to FIG. 14. In this example, distances between the left and right first fasteners 600 located in the first-direction extension area 220 and the vertical center line *l*2 of the chip layout area 210 are C. Because C is basically equal to the distance A between the first fastener 600 and the vertical center line *l*2 in the first layout manner of the first fastener 600, the forces applied to the second clamping member 500 by the first fasteners on the left and right sides of the first-direction extension area 220 may also be equivalent to F1 and F2.

It can be learned from the basic knowledge of material mechanics that, in this example, that is, in the second case of the first example, a deflection (that is, a deformation amount) that is generated by the second clamping member 500 is less than that generated by the second clamping member 500 in the first layout manner.

In this embodiment of this application, the at least four first fasteners 600 are all disposed in extension areas of the chip 200 in two directions, and are disposed around the chip 200. This ensures an overall effect of locking the first clamping member 100 and the second clamping member 500, and correspondingly reduces distances between some first fasteners 600 and a center line of the chip layout area 210 (for example, distances between the first fasteners 600 in the second-direction extension area 230 and the vertical center line *l*2), that is, reduces distances between some load support points of the chip assembly and the center line of the chip layout area 210, thereby improving rigidity of the chip assembly, reducing deformation amounts of the circuit board 400, the first clamping member 100, the second clamping member 500, and the like, improving evenness of force distribution of the chip socket 300, and ensuring good electrical contact between two sides of the chip socket 300 and the chip 200 or between the chip socket 300 and the circuit board 400.

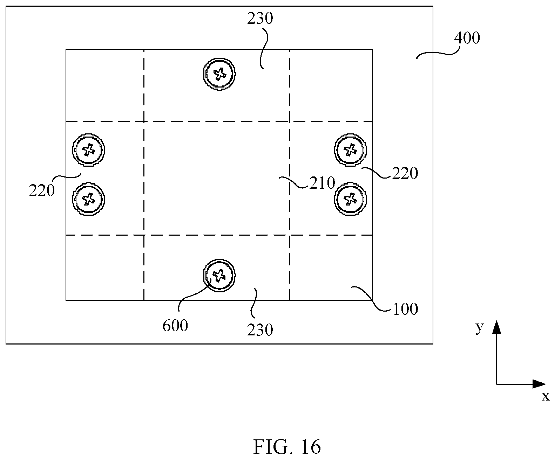

FIG. 16 is a top view of still another chip assembly according to an embodiment of this application. Refer to FIG. 16. In the foregoing second case, two or more first fasteners 600 may be disposed in the left and right first-direction extension area 220 of the chip 200, or two or more first fasteners 600 may be disposed in both the upper and lower second-direction extension areas 230 of the chip 200. For example, one first fastener 600 is disposed in each of the second-direction extension areas 230 on the upper and lower sides of the chip 200, and two first fasteners 600 are respectively disposed in the first-direction extension areas 220 on the left and right sides of the chip 200, so as to further improve structural stability of the chip assembly.

Certainly, a plurality of first fasteners 600 may be disposed in the first-direction extension areas 220 on the left and right sides, and a plurality of first fasteners 600 may be disposed in the second-direction extension areas 230 on the upper and lower sides. For example, two first fasteners 600 are respectively disposed in the second-direction extension areas 230 on the upper and lower sides of the chip 200, and two first fasteners 600 are respectively disposed in the first-direction extension areas 220 on the left and right sides of the chip 200. This may be specifically adjusted according to an actual requirement.

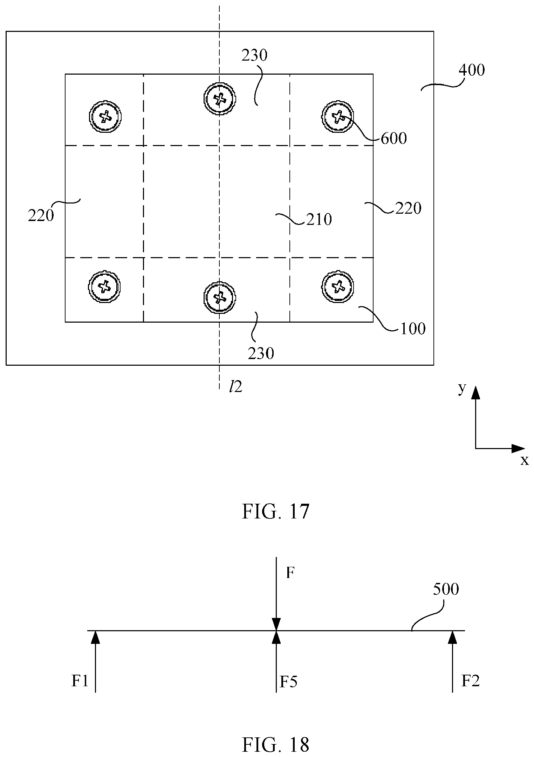

FIG. 17 is a top view of still another chip assembly according to an embodiment of this application. Refer to FIG. 17. In the second layout manner, the second example of the first fastener 600 is as follows:

In the plurality of first fasteners 600, at least two first fasteners 600 are distributed on a periphery of the chip layout area 210, the at least two first fasteners 600 are spaced from the first-direction extension area 220 and the second-direction extension area 230, and at least one first fastener 600 is disposed in the first-direction extension area 220 or the second-direction extension area 230 of the chip 200.

In actual application, at least four first fasteners 600 are evenly distributed on the periphery of the chip layout area 210, at least four first fasteners 600 are spaced from the first-direction extension area 220 and the second-direction extension area 230, and at least one first fastener 600 is disposed in the first-direction extension area 220 or the second-direction extension area 230 of the chip 200.

It should be noted that, in this example, one first fastener 600 may be disposed in an extension area of the chip 200, and the first fastener 600 may be disposed in the first-direction extension area 220, or may be disposed in the second-direction extension area 230. Certainly, in this example, two or more first fasteners 600 may be alternatively disposed in the extension area of the chip 200.

When a plurality of first fasteners 600 are disposed in the extension area of the chip 200, the plurality of first fasteners 600 may be randomly disposed in the first-direction extension area 220 or the second-direction extension area 230, or reference may be made to the first example.

Refer to FIG. 17. For example, there may be at least six first fasteners 600. Four first fasteners 600 are evenly distributed on the periphery of the chip layout area 210, and are spaced from the first-direction extension area 220 and the second-direction extension area 230. For example, the four first fasteners 600 are respectively disposed at four corners of the chip assembly.

In addition, at least two first fasteners 600 are all disposed in the first-direction extension area 220 of the chip 200, and at least two first fasteners 600 are respectively located on two sides of the chip layout area 210 along the first direction. Alternatively, refer to FIG. 15, where at least two first fasteners 600 are all disposed in the second-direction extension area 230 of the chip 200, and at least two first fasteners 600 are respectively located on two sides of the chip layout area 210 along the second direction.

For example, as shown in FIG. 17, there are six first fasteners 600, where four first fasteners 600 are respectively disposed at four corners of the chip assembly, and the other two first fasteners 600 are respectively disposed in the second-direction extension areas 230 on the upper and lower sides of the chip layout area 210, and are located on the vertical center line *l*2 of the chip layout area 210.

FIG. 18 is an equivalent principle diagram of force distribution of the second clamping member in FIG. 17. Refer to FIG. 18. Action forces applied to the second clamping member 500 by loading points of two pairs of first fasteners 600 located at four corners of the chip assembly may be equivalent to F1 and F2, an action force applied to the second clamping member 500 by a loading point of the first fastener 600 located in the second-direction extension area 230 of the chip 200 may be equivalent to F5, and an action force applied to the second clamping member 500 by the chip socket 300 may be equivalent to F applied to the middle position of the second clamping member 500.

It can be learned from basic knowledge of material mechanics that, a deflection (that is, a deformation amount) generated by the second clamping member 500 in this example, that is, in the second example of the second layout manner, is less than that generated by the second clamping member 500 in the first example.

It can be learned from the foregoing descriptions that, in this embodiment of this application, at least four first fasteners 600 are evenly distributed on the periphery of the chip layout area 210, and are spaced from the first-direction extension area 220 and the second-direction extension area 230 of the chip 200, and at least one first fastener 600 is disposed in the first-direction extension area 220 or the second-direction extension area 230. That is, load support points are evenly distributed at four corners on the periphery of the chip 200, and load support points are added to the extension areas 230 of the chip 200, so as to disperse the centralized load. This improves an effect of fastening the chip assembly by the first fastener 600, and reduces spacings between the first fasteners 600, that is, reduces spacings between load support points of the chip assembly, thereby improving rigidity of the chip assembly, reducing deformation amounts of the circuit board 400, the first clamping member 100, the second clamping member 500, and the like, improving evenness of force distribution of the chip socket 300, and ensuring good electrical contact between two sides of the chip socket 300 and the chip 200 or between the chip socket 300 and the circuit board 400.

It may be understood that, in the second example of the second layout manner, a quantity of first fasteners 600 located outside the extension area of the chip 200 may be equal to or less than three. For example, three first fasteners 600 are located outside the extension area of the chip 200, and the three first fasteners 600 are respectively disposed at any three of four corners of the periphery of the chip layout area 210. Refer to FIG. 16. For example, one first fastener 600 is disposed at each of an upper left corner, an upper right corner, and a lower left corner on the periphery of the chip layout area 210.

In this embodiment of this application, a quantity of first fasteners 600 located outside the extension area of the chip 200 is not specifically limited, and may be specifically adjusted according to an actual requirement.

It should be noted herein that the second layout manner of the first fastener 600 may be an improvement made based on a chip assembly having a protruding portion 501 in the second clamping member 500. For example, the second clamping member 500 of the chip assembly has the protruding portion 501, and a plurality of first fasteners 600 are disposed in the chip assembly in the second layout manner, to lock the first clamping member 100 and the second clamping member 500 of the chip assembly, so as to assemble the chip assembly. This further ensures close contact between the chip and the chip socket or between the chip socket and the circuit board, thereby implementing a stable electrical connection between the chip and the circuit board.

Certainly, in some examples, the second layout manner of the first fastener 600 may alternatively be an improvement made based on a chip assembly in a related technology. For example, the second clamping member 500 of the chip assembly directly uses a backplane in the related technology, that is, no protruding portion 501 is disposed on the backplane, and a plurality of first fasteners 600 are disposed in the chip assembly in the second layout manner, to lock the first clamping member 100 and the second clamping member 500 of the chip assembly, so as to assemble the chip assembly. This ensures close contact between the chip and the chip socket or between the chip socket and the circuit board, thereby implementing a stable electrical connection between the chip and the circuit board.

Refer to FIG. 3. The chip assembly in this embodiment of this application may further include a holder 700 and a second fastener. The holder 700 is located on a side that is of the circuit board 400 and that is away from the second clamping member 500, and the holder 700 has a mounting opening 710. When the holder 700 is assembled on the circuit board 400, the chip socket 300 is located in the mounting opening 710 on the holder 700, the chip 200 passes through the mounting opening 710 on the holder 700 and is in electrical contact with the chip socket 300, and the second fastener is sequentially penetrated into the second clamping member 500, the circuit board 400, and the holder 700. For example, the circuit board 400 is locked between the holder 700 and the plate-like member by using the second fastener.

The holder 700 may be made of a material such as stainless steel, and the plate-like member is made of a carbon steel material. Rigidity of the stainless steel and rigidity of the carbon steel material are greater than rigidity of the circuit board 400.

In this embodiment of this application, the holder 700 is disposed on a side that is of the circuit board 400 and that is away from the second clamping member 500, so that the circuit board 400 is locked between the holder 700 and the second clamping member 500 by using the second fastener. This further improves rigidity of the circuit board 400, and reduces a deformation amount of the circuit board 400 in the chip assembly, thereby further ensuring that force distribution of the chip terminal 310 is more even. In addition, the chip 200 and the chip socket 300 are limited in the mounting opening 710 of the holder 700, to improve stability of the chip 200 and the chip socket 300 in a horizontal direction, so as to further ensure good contact between the chip 200 and the chip terminal 310.

During specific disposition, the second fastener may be a mechanical part such as a screw, a bolt, or a rivet. Refer to FIG. 3. For example, the second fastener may include a second screw 800 and a nut 900, where the nut 900 is disposed on the holder 700, and the second screw 800 is sequentially penetrated into the second clamping member 500, the circuit board 400, and the holder 700 and is connected to the nut 900 through threads.

For example, a mounting hole may be provided on the holder 700, and the nut 900 is fastened in the mounting hole. In addition, one side of the second screw 800 is pre-fastened on the lower clamping member 520 of the second clamping member 500, and a screw hole 410 is provided on the upper clamping member 510 and the circuit board 400. During assembly, the other side of the second screw 800 sequentially passes through the upper clamping member 510 and the circuit board 400 and is connected to the nut 900 on the holder 700, so that the holder 700, the circuit board 400, and the second clamping member 500 are locked.

There may be two or more second fasteners. For example, there may be two or more second screws 800, and a quantity of nuts 900 matches that of second screw holes. For example, two second screws 800 are disposed on the left and right sides of the second clamping member 500 in the horizontal direction. Correspondingly, two nuts 900 are disposed on each of the left and right sides of the holder 700 in the horizontal direction. The four second screws 800 sequentially pass through the circuit board 400 and are connected to the nuts 900 of the holder 700 through threads, thereby improving an effect of locking the holder 700, the circuit board 400, and the second clamping member 500. A quantity of second fasteners is not limited in this embodiment of this application, and may be specifically adjusted according to an actual requirement.

It should be noted herein that, when the chip assembly in this embodiment of this application includes the holder 700 and the second fastener, the second clamping member 500, the circuit board 400, the chip socket 300, and the chip 200 are fastened by using the second fastener. In this case, the first fasteners 600 in this embodiment of this application may be disposed only on the first clamping member 100 and the holder 700, so that the entire chip assembly can be locked.

During specific disposition, each first fastener 600 may be a mechanical part such as a screw, a rivet, or a bolt.

Refer to FIG. 2 and FIG. 3. For example, each first fastener 600 may include a first screw 610 and a screw cap 620. The screw cap 620 is penetrated into the first clamping member 100. For example, a mounting hole is provided on the first clamping member 100, for example, a heat sink, a screw cap 620 is fastened in the mounting hole, and two sides of the screw cap 620 pass through an upper surface and a lower surface of the first clamping member 100.

Some of the first screws 610 are penetrated into the holder 700 and the first clamping member 100 and are connected to the screw cap 620 through threads, and some other first screws 610 are sequentially penetrated into the second clamping member 500, the circuit board 400, the holder 700, and the first clamping member 100 and are connected to the screw cap 620 through threads.

For example, there are six first fasteners 600, where two first fasteners 600 are respectively located in the second-direction extension areas 230 on the upper and lower sides of the chip 200, and in the other four first fasteners 600, every two first fasteners 600 are respectively located in the first-direction extension areas 220 on the left and right sides of the chip 200. Correspondingly, six mounting holes are disposed on the first clamping member 100, for example, a heat sink, and one screw cap 620 is correspondingly disposed in each mounting hole. In the six screw caps 620, two screw caps 620 are respectively located in the second-direction extension areas 230 on the upper and lower sides of the chip 200. In the other four screw caps 620, every two screw caps 620 are respectively located in the first-direction extension areas 220 on the left and right sides of the chip 200. In addition, the first screws 610 corresponding to the four screw caps 620 located in the first-direction extension areas 220 are respectively disposed at corresponding positions of the holder 700, and the first screws 610 corresponding to the two screw caps 620 located in the second-direction extension area 230 are respectively disposed at corresponding positions of the second clamping member 500. Correspondingly, screw holes 410 corresponding to the first screws 610 in the second-direction extension area 230 are disposed on the circuit board 400 and the holder 700. In this way, during assembly, the two first screws 610 located on the second clamping member 500 sequentially pass through the circuit board 400 and the holder 700 and are connected to the screw cap 620 on the first clamping member 100 through threads. One side of each of the four first screws 610 located on the holder 700 is connected to the four corresponding screw caps 620 on the first clamping member 100 through threads, so as to complete locking of the entire chip assembly.

It may be understood that, in some examples, two first screws 610 corresponding to the second-direction extension area 230 may be disposed on the holder 700, and four first screws 610 corresponding to the first-direction extension area 220 may be disposed on the second clamping member 500. A quantity of first screws 610 fastened to the holder 700 or the second clamping member 500 is not specifically limited in this embodiment of this application, provided that it is ensured that all the first fasteners 600 can lock the first clamping member 100 and the second clamping member 500 together.

For example, in some examples, all the first screws 610 may be disposed on the holder 700, and one side of each first screw 610 is penetrated into the first clamping member 100 and is connected to the screw cap 620 on the first clamping member 100 through threads, to lock the first clamping member 100 and the second clamping member 500 in combination with the second screw 800, so as to fasten the entire chip assembly.

During specific disposition, the screw cap 620 may be embedded in the mounting hole of the first clamping member 100, for example, the heat sink, through interference fitting, so as to improve stability of the screw cap 620 on the first clamping member 100.

Refer to FIG. 3. To further improve a locking effect, the first fastener 600 may further include an elastic member 630, where the elastic member 630 is sleeved on the screw cap 620, and the elastic member 630 is located on a side that is of the first clamping member 100 and that is away from the chip 200. Two sides of the elastic member 630 respectively abut against the screw cap 620 and the first clamping member 100. The elastic member 630 may be a spring.

In a locking process of the first fastener 600, the elastic member 630 is pressed, so as to generate a downward pressure on the first clamping member 100 and an upward pulling force on the second clamping member 500. This pair of interaction forces is respectively transferred by the chip 200 and the circuit board 400 and then applied to the chip socket 300, so that a chip terminal 310 on one side of the chip socket 300 is correspondingly compressed, to form a specific normal force of the chip terminal. This further ensures good contact between the chip terminal 310 of the chip socket 300 and the chip 200 or between the chip terminal 310 and the circuit board 400.

An embodiment of this application further provides an electronic device. The electronic device includes at least one chip assembly according to any one of the foregoing embodiments.

In this embodiment of this application, the chip assembly of the foregoing structure is disposed in the electronic device, so that a stable electrical connection between an internal chip and a circuit board can be implemented, thereby ensuring normal operation of the chip, avoiding a problem that the circuit board is damaged due to stress concentration, and prolonging a service life of the entire chip assembly.

The electronic device includes but is not limited to a mobile or fixed terminal having a chip assembly, such as a server, a television, a mobile phone, a tablet computer, a notebook computer, an ultra-mobile personal computer (ultra-mobile personal computer, UMPC for short), a handheld computer, a walkie-talkie, a netbook, a POS machine, a personal digital assistant (personal digital assistant, PDA for short), a wearable device, a virtual reality device, or a switch.

### Embodiment 2

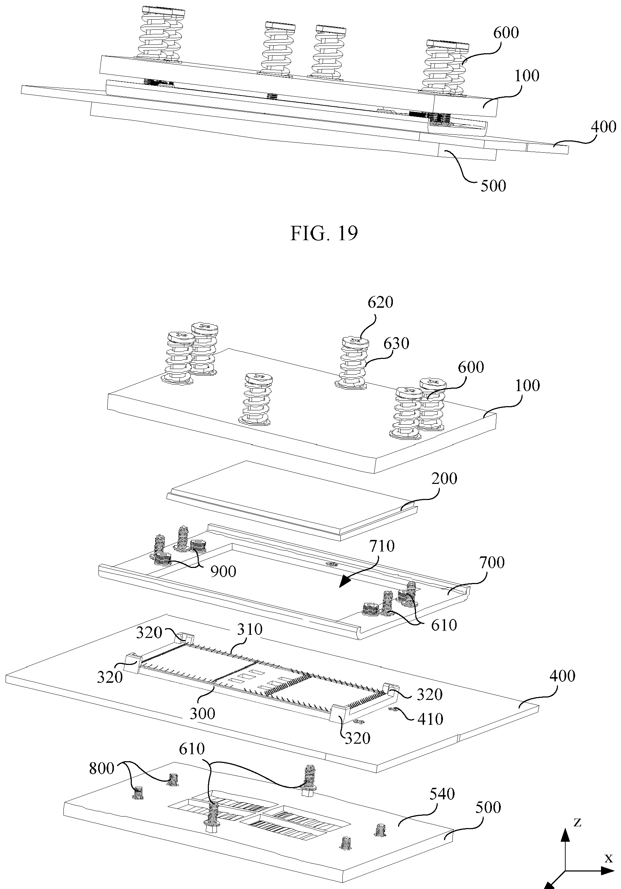

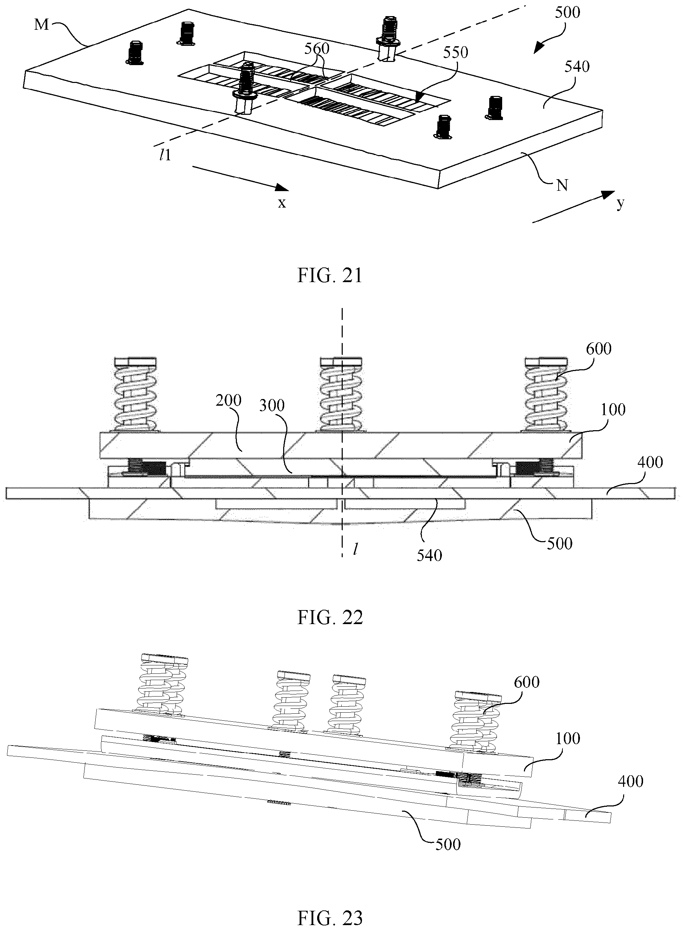

FIG. 19 is an assembly diagram of still another chip assembly according to an embodiment of this application; FIG. 20 is an exploded structural view of FIG. 19; and FIG. 21 is a schematic diagram of a structure of a second clamping member in FIG. 20. Refer to FIG. 19 to FIG. 21. Different from Embodiment 1, in the chip assembly provided in this embodiment of this application, a surface that is of the second clamping member 500 and that faces the circuit board 400 is a curved surface 540 bending in a direction towards the circuit board 400, so that a protruding portion 501 is formed on a side that is of the second clamping member 500 and that faces the circuit board 400.

For example, the second clamping member 500 is a plate-like member. In actual application, the plate-like member may be a backplane, and a surface that is of the plate-like member and that faces the circuit board 400 is a curved surface 540 bending in a direction towards the circuit board 400. The second clamping member 500 is disposed as a plate-like member, so that the plate-like member can not only be used for packaging the chip 200, but also avoid damage caused by stress concentration on the circuit board 400, thereby simplifying the chip assembly.

Refer to FIG. 21. In a first possible implementation, the upper surface of the plate-like member may be an arc-shaped surface that is high at both ends and low in the middle. Specifically, the plate-like member includes a first end M and a second end N that are disposed opposite to each other along an extension direction, a highest contour line of the curved surface 540 is located on an axisymmetric line *l*1 of the first end M and the second end N, and lowest contour lines of the curved surface 540 are respectively located on the first end M and the second end N, so that the curved surface 540 of the plate-like member is high at both ends and low in the middle.

The extension direction of the plate-like member is consistent with a length direction of the chip assembly, that is, a direction x.

A plate-like member of a rectangular structure is used as an example. A surface that is of the plate-like member and that faces the circuit board 400 has a center line parallel to a width direction (for example, a direction y in FIG. 20). The center line may be considered as an axisymmetric line *l*1 of a first end M and a second end N that are of the plate-like member and that are disposed in an extension direction. A highest contour line of the curved surface 540 of the plate-like member is located on the axisymmetric line *l*1, and a lowest contour line of the curved surface 540 is located at the first end M and the second end N. In other words, the axisymmetric line *l*1 of the plate-like member is a highest line of the curved surface 540, and the curved surface 540 is gradually lowered from the axisymmetric line *l*1 to two ends of the plate-like member, to finally present a structure in which the axisymmetric line *l*1 of the plate-like member is located at a higher position and the first end M and the second end N of the plate-like member are lower.

In this embodiment of this application, the highest contour line of the curved surface 540 is located on the axisymmetric line *l*1 of the first end M and the second end N of the plate-like member, and the lowest contour lines of the curved surface 540 is located on the first end M and the second end N of the plate-like member. In this way, the curved surface 540 of the plate-like member is curved like an arch bridge, and the axisymmetric line *l*1 of the two ends of the plate-like member is the highest contour line of the curved surface 540, so that an area in which the entire axisymmetric line *l*1 of the plate-like member is located may support the circuit board 400, that is, the plate-like member has a butting function for each position of the circuit board 400 in a width direction, thereby further ensuring that the circuit board 400 in a locked state does not bend in a direction away from the chip 200.

In a second possible implementation, the curved surface 540 on one side of the plate-like member may be an arc surface (not shown in the figure). For example, a center symmetry point of the first end M and the second end N of the plate-like member is a highest point of the arc surface, and the arc surface is gradually lowered from the center symmetry point of the plate-like member to an outer edge of the plate-like member, to finally present a structure in which a center symmetry point of the plate-like member is high and an outer edge of the plate-like member is lower.

FIG. 22 is a longitudinal sectional view of FIG. 19. Refer to FIG. 22. In this embodiment of this application, a surface that is of the second clamping member 500 and that faces the circuit board 400 is disposed as a curved surface 540, and the curved surface 540 bends in a direction towards the circuit board 400. In this way, after the first fastener 600 locks the entire chip assembly, the curved surface 540 that is of the second clamping member 500 and that bends towards the circuit board 400 supports the chip layout area 210 of the circuit board 400. For example, the second clamping member 500 may abut against the circuit board 400 to a horizontal state or to bend in a direction towards the chip 200, so as to ensure that two sides of the chip socket 300 are respectively in close contact with the chip 200 and the circuit board 400, thereby improving evenness of force distribution of the chip terminal 310, and further ensuring that two sides of the chip socket 300 are respectively in good electrical connection to the chip 200 and the circuit board 400.

Specifically, due to rigidity of the second clamping member 500, locking forces of the first fasteners 600, and the like, the circuit board 400 presents the following locked states under press-fitting of the second clamping member 500.

Refer to FIG. 22. As a locked state, after the first fastener 600 locks the chip assembly, a middle area of a lower surface of the second clamping member 500 bends in a direction away from the chip 200, and a curved surface 540, that is, a slightly protruding structure, on the second clamping member 500 moves downward for a specific distance when transferring a clamping force to the circuit board 400, so that the chip layout area 210 of the circuit board 400, that is, the middle area, presents a horizontal state under abutting of the curved surface 540 of the second clamping member 500. This prevents the circuit board 400 from bending downward, that is, from bending in a direction away from the chip 200, and avoids a gap between the chip socket 300 and the chip 200 or between the chip socket 300 and the circuit board 400, so that force distribution of the chip terminals 310 on the chip socket 300 is more even, thereby ensuring that the chip socket 300 is in good contact with the chip 200 or the chip socket 300 is in good contact with the circuit board 400, and further ensuring reliability of an electrical connection between the chip 200 and the circuit board 400.

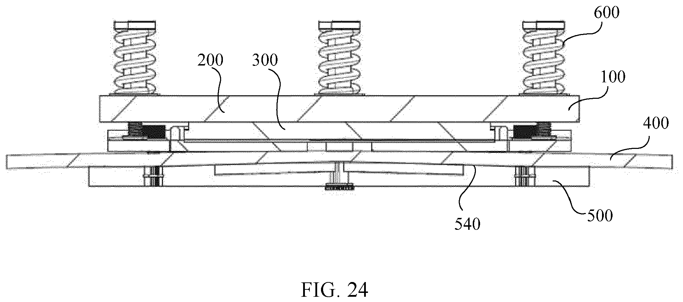

FIG. 23 is another assembly diagram of still another chip assembly according to an embodiment of this application; and FIG. 24 is a longitudinal sectional view of FIG. 23. Refer to FIG. 23 and FIG. 24. As a second locked state, after the first fastener 600 locks the chip assembly, a middle area of the second clamping member 500 slightly bends in a direction away from the chip 200, so that the slightly protruding structure of the curved surface 540 of the second clamping member 500 abuts against the chip layout area 210 (that is, the middle area) of the circuit board 400 to bend upward, that is, to bend in a direction towards the chip 200. This further avoids a gap between the chip socket 300 and the chip 200 or between the chip socket 300 and the circuit board 400, so that the force distribution of the chip terminals 310 on the chip socket 300 is more even, thereby ensuring that the chip socket 300 is in good contact with the chip 200 or the chip socket 300 is in good contact with the circuit board 400, and further ensuring reliability of an electrical connection between the chip 200 and the circuit board 400.

Certainly, another locked state is not excluded in this embodiment of this application, and a locked state of the chip assembly in this embodiment of this application is not limited herein, provided that it is ensured that the chip layout area 210 of the circuit board 400 has a specific clamping force on two sides of the chip socket 300 under the support of the second clamping member 500, so as to ensure that force distribution of the chip terminals 310 on the chip socket 300 is more even, and ensure that electrical contact between the chip socket 300 and the chip 200 is more reliable.

In addition, the outer edge of the second clamping member 500 is located on a periphery of the area enclosed by all loading points of the first fasteners 600, that is, the load support points; and in the locked state, the curved surface 540 of the second clamping member 500 is in good contact with each position of the circuit board 400. This ensures continuity of an action force between each position of the second clamping member 500 inside the load support point and the circuit board 400, and avoids stress concentration on the circuit board 400, thereby ensuring that the circuit board 400 is not damaged, and prolonging a service life of the chip assembly.

Refer to FIG. 24. During specific disposition, at least a part of a highest area of the curved surface 540 of the second clamping member 500 is located on the chip 200, so that when the chip assembly in this embodiment of this application is in a locked state, the highest area of the curved surface 540 of the second clamping member 500 just abuts against an area that is of the chip 200 and that is corresponding to a center of the circuit board 400, thereby further improving close contact between two sides of the chip socket 300 and the circuit board 400 and the chip 200. This ensures good electrical contact between the chip socket 300 and the chip 200 or between the chip socket 300 and the circuit board 400, thereby implementing a stable electrical connection between the chip 200 and the circuit board 400.

Refer to FIG. 21. During specific disposition of the second clamping member 500 in this embodiment of this application, a side that is of the second clamping member 500 and that is away from the circuit board 400 may be a planar structure. For example, when the second clamping member 500 is a plate-like member, a side surface that is of the plate-like member and that is away from the circuit board 400 is a planar surface, and a side that is of the plate-like member and that faces the circuit board 400 is a curved surface 540. This ensures that the curved surface 540 of the plate-like member provides a supporting function for the circuit board 400, ensures that no stress concentration occurs on the circuit board 400, and simplifies a structure of the plate-like member, so that forming of the plate-like member is simplified, thereby improving manufacturing efficiency of the chip assembly.

When the plate-like member is of the foregoing first implementable structure, a thickness of the plate-like member gradually decreases in a direction from the axisymmetric line 11 to the first side M or the second end N; or when the plate-like member is of the foregoing second implementable structure, a thickness of the plate-like member gradually decreases in a direction from the center point to the outer edge of the plate-like member.

Certainly, in another example, a side surface that is of the second clamping member 500 and that is away from the circuit board 400 is also a curved surface 540, and a bending direction and a bending degree of the curved surface 540 are consistent with those of the curved surface 540 that is of the second clamping member 500 and that faces the circuit board 400. In other words, the thickness of the second clamping member 500 is equal everywhere. For example, two surfaces of the plate-like member along the thickness direction are curved surfaces 540 bending in the direction towards the circuit board 400, and the thickness of the plate-like member is equal everywhere.

Refer to FIG. 21. To prevent the second clamping member 500 from causing damage to an electronic component in a process of assembling a chip assembly, an avoidance groove 550 is formed in a position that is of the electronic component and that is corresponding to the second clamping member 500 in this embodiment. In this way, after the second clamping member 500 is attached to the circuit board 400, the electronic component is just located in the avoidance groove 550. This ensures that the second clamping member 500 is closely attached to the circuit board 400, avoids a case in which stress concentration occurs on the circuit board 400 due to a gap between the second clamping member 500 and the circuit board 400, and avoids a case in which the second clamping member 500 squeezes and causes damage to the electronic component, thereby ensuring normal operation of the electronic component.

It may be understood that a size and a shape of the avoidance groove 550 may match an electronic component on the circuit board 400. This not only implements a function of avoiding the electronic component, but also avoids a case in which a structural strength of the second clamping member 500 is reduced because the avoidance groove 550 is excessively large.

Certainly, there may be one avoidance groove 550. One avoidance groove 550 is configured to accommodate a plurality of electronic components.

In actual application, electronic components are centrally arranged in an orthographic projection area of the chip 200 on the circuit board 400, that is, the electronic components are disposed in the chip layout area 210 of the circuit board 400. To ensure that the middle area of the second clamping member 500 can abut against the chip layout area 210 of the circuit board 400, in this embodiment of this application, a second stiffener 560 is disposed in the avoidance groove 550, and at least a part of an orthographic projection area of the second stiffener 560 on the circuit board 400 is disposed in the orthographic projection area of the chip 200, to ensure that the second stiffener 560 on the second clamping member 500 can transfer an action force to the chip layout area 210 of the circuit board 400, so that the chip layout area 210 of the circuit board 400 is supported by the second stiffener 560. For example, under the support of the second stiffener 560, the chip layout area 210 of the circuit board 400 may be in a horizontal state or bend in a direction towards the chip 200, so as to ensure close contact between the chip socket 300 and the chip 200 and between the chip socket 300 and the circuit board 400.

In addition, the second stiffener 560 is disposed in the avoidance groove 550, to further reinforce a structure of the avoidance groove 550, so as to ensure structural stability of the avoidance groove 550 on the second clamping member 500.

For a specific manner of disposing the second stiffener 560 in this embodiment of this application, refer to the manner of disposing the first stiffener 512 in Embodiment 1. Details are not described herein again.

In descriptions of embodiments of this application, it should be noted that, unless otherwise clearly specified and limited, the terms "mounting", "connection to", and "connection" should be understood in a broad sense. For example, the connection may be a fixed connection, may be an indirect connection by using an intermediate medium, or may be an internal connection between two elements or an interaction relationship between two elements. For a person of ordinary skill in the art, specific meanings of the foregoing terms in embodiments of this application may be understood according to a specific situation.

In the specification, claims, and accompanying drawings in embodiments of this application, the terms "first", "second", "third", "fourth", and so on (if available) are intended to distinguish between similar objects but do not necessarily indicate a specific order or sequence.

## Claims

1. A chip assembly, comprising a first clamping member, a chip, a chip socket, a circuit board, and a second clamping member that are sequentially stacked, wherein the chip is electrically connected to the circuit board through the chip socket, and at least one side of the chip socket is in electrical contact with the chip or the circuit board;
the chip assembly further comprises a plurality of first fasteners, the plurality of first fasteners are disposed around the chip at intervals, and the first fasteners are configured to lock the first clamping member and the second clamping member; and
the second clamping member has a protruding portion extending in a direction towards the first clamping member, the protruding portion is located in an area enclosed by all the first fasteners, and at least a part of an orthographic projection area of the protruding portion on the circuit board is located in an orthographic projection area of the chip on the circuit board.

2. The chip assembly according to claim 1, wherein the orthographic projection area of the protruding portion on the circuit board is located in the orthographic projection area of the chip on the circuit board.

3. The chip assembly according to claim 1 or 2, wherein the second clamping member comprises an upper clamping member, a lower clamping member, and a middle member located between the upper clamping member and the lower clamping member, the upper clamping member is located on a side surface of the circuit board, and the middle member is configured as the protruding portion.

4. The chip assembly according to claim 3, wherein an outer edge of the upper clamping member is located outside the area enclosed by all the first fasteners.

5. The chip assembly according to claim 3 or 4, wherein an electronic component is disposed on a side surface that is of the circuit board and that faces the second clamping member; and
an avoidance hole is formed in a position that is of the upper clamping member and that is corresponding to the electronic component.

6. The chip assembly according to claim 5, wherein the electronic component is located in the orthographic projection area of the chip on the circuit board; and
a first stiffener is disposed in the avoidance hole, and at least a part of the first stiffener is in contact with the middle member.

7. The chip assembly according to any one of claims 3 to 6, wherein the middle member and the lower clamping member are an integral part that is integrally formed.

8. The chip assembly according to any one of claims 3 to 7, wherein the second clamping member is a plate-like member, the plate-like member comprises a first plate-like member, a second plate-like member, and a middle portion, the middle portion is located between the first plate-like member and the second plate-like member, and the first plate-like member is located on a side surface of the circuit board; and
the middle portion is located in the area enclosed by all the first fasteners, and at least a part of an orthographic projection area of the middle portion on the circuit board is located in the orthographic projection area of the chip on the circuit board.

9. The chip assembly according to claim 1 or 2, wherein a surface that is of the second clamping member and that faces the circuit board is a curved surface bending in a direction towards the circuit board, so that the protruding portion is formed on a side that is of the second clamping member and that faces the circuit board.

10. The chip assembly according to claim 9, wherein at least a part of a highest area of the curved surface is located in an orthographic projection area of the chip on the second clamping member.

11. The chip assembly according to claim 9 or 10, wherein the second clamping member is a plate-like member, and a surface that is of the plate-like member and that faces the circuit board is a curved surface bending in the direction towards the circuit board.

12. The chip assembly according to claim 11, wherein the plate-like member comprises a first end and a second end that are disposed opposite to each other along an extension direction; and
a highest contour line of the curved surface is located on an axisymmetric line of the first end and the second end, and lowest contour lines of the curved surface are respectively located on the first end and the second end.

13. The chip assembly according to claim 12, wherein a side surface that is of the plate-like member and that is away from the circuit board is a plane, and a thickness of the plate-like member gradually decreases in a direction from the axisymmetric line to the first end or the second end.

14. The chip assembly according to any one of claims 9 to 13, wherein an electronic component is disposed on a side surface that is of the circuit board and that faces the second clamping member; and
an avoidance groove is formed in a position that is of the second clamping member and that is corresponding to the electronic component.

15. The chip assembly according to claim 14, wherein the electronic component is located in the orthographic projection area of the chip on the circuit board; and
a second stiffener is disposed in the avoidance groove, and at least a part of an orthographic projection area of the second stiffener on the circuit board is located in the orthographic projection area of the chip on the circuit board.

16. The chip assembly according to any one of claims 1 to 15, wherein at least one of the first fasteners is disposed in a first-direction extension area or a second-direction extension area of the chip; and
the first-direction extension area is an extension area of a chip layout area in a first direction, and the second-direction extension area is an extension area of the chip layout area in a second direction, wherein the first direction and the second direction are perpendicular to each other.

17. The chip assembly according to claim 16, wherein at least two of the first fasteners are all disposed in the first-direction extension area, and at least two of the first fasteners are respectively located on two sides of the chip layout area along the first direction; or
at least two of the first fasteners are all disposed in the second-direction extension area, and at least two of the first fasteners are respectively located on two sides of the chip layout area along the second direction; or
at least two of the first fasteners are all disposed in the first-direction extension area, at least two of the first fasteners are respectively located on two sides of the chip layout area along the first direction, at least two of the first fasteners are all disposed in the second-direction extension area, and at least two of the first fasteners are respectively located on two sides of the chip layout area along the second direction.

18. The chip assembly according to any one of claims 1 to 17, wherein the chip assembly further comprises a holder and a second fastener; and
the holder is located on a side that is of the circuit board and that is away from the second clamping member, the chip socket is located in a mounting opening on the holder, the chip passes through the mounting opening on the holder and is in electrical contact with the chip socket, and the second fastener is sequentially penetrated into the second clamping member, the circuit board, and the holder.

19. The chip assembly according to any one of claims 1 to 18, wherein chip terminals are provided on two sides of the chip socket that are opposite to each other in a thickness direction of the chip socket, and two sides of the chip socket are in electrical contact with both the chip and the circuit board through the chip terminals.

20. A chip assembly, comprising a first clamping member, a chip, a chip socket, a circuit board, and a second clamping member that are sequentially stacked, wherein the chip is electrically connected to the circuit board through the chip socket, and at least one side of the chip socket is in electrical contact with the chip or the circuit board;
the chip assembly further comprises a plurality of first fasteners, the plurality of first fasteners are disposed around the chip at intervals, and the first fasteners are configured to lock the first clamping member and the second clamping member; and
at least one of the first fasteners is disposed in a first-direction extension area or a second-direction extension area of the chip; and the first-direction extension area is an extension area of a chip layout area in a first direction, and the second-direction extension area is an extension area of the chip layout area in a second direction, wherein the first direction and the second direction are perpendicular to each other.

21. The chip assembly according to claim 20, wherein at least two of the first fasteners are all disposed in the first-direction extension area, and at least two of the first fasteners are respectively located on two sides of the chip layout area along the first direction; or
at least two of the first fasteners are all disposed in the second-direction extension area, and at least two of the first fasteners are respectively located on two sides of the chip layout area along the second direction.

22. The chip assembly according to claim 20 or 21, wherein in the plurality of first fasteners, at least four of the first fasteners are evenly distributed on a periphery of the chip layout area, and the at least four of the first fasteners are all spaced from the first-direction extension area and the second-direction extension area of the chip.

23. The chip assembly according to claim 21 or 22, wherein at least two of the first fasteners are all disposed in the first-direction extension area, at least two of the first fasteners are respectively located on two sides of the chip layout area along the first direction, at least two of the first fasteners are all disposed in the second-direction extension area, and at least two of the first fasteners are respectively located on two sides of the chip layout area along the second direction.

24. An electronic device, comprising at least one chip assembly according to any one of claims 1 to 23.
